(19) Europäisches Patentamt
European Patent Office
Office européen des brevets

(11) **EP 3 805 718 B1**

(12) **EUROPEAN PATENT SPECIFICATION**

(45) Date of publication and mention
of the grant of the patent:
**26.06.2024 Bulletin 2024/26**

(21) Application number: **19815265.4**

(22) Date of filing: **07.05.2019**

(51) International Patent Classification (IPC):
*G01J 5/02* (2022.01)   *G01J 1/02* (2006.01)
*G01J 1/42* (2006.01)   *H01L 27/144* (2006.01)
*H01L 27/146* (2006.01)   *H04N 5/33* (2023.01)
*G01J 5/08* (2022.01)   *G01J 5/20* (2006.01)
*G01J 5/00* (2022.01)

(52) Cooperative Patent Classification (CPC):
**H01L 27/14609; G01J 5/0853; G01J 5/20;**
**H01L 27/14603; H01L 27/14621; H01L 27/14649;**
G01J 2005/0077

(86) International application number:
**PCT/JP2019/018222**

(87) International publication number:
**WO 2019/235115 (12.12.2019 Gazette 2019/50)**

(54) **IMAGING DEVICE**

BILDGEBUNGSVORRICHTUNG

DISPOSITIF D'IMAGERIE

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **05.06.2018 JP 2018107750**

(43) Date of publication of application:
**14.04.2021 Bulletin 2021/15**

(73) Proprietor: **Sony Semiconductor Solutions**
**Corporation**
**Atsugi-shi, Kanagawa 243-0014 (JP)**

(72) Inventors:
• **OKUMURA Kenichi**
**Atsugi-shi, Kanagawa 243-0014 (JP)**
• **HOSAKA Hajime**
**Atsugi-shi, Kanagawa 243-0014 (JP)**
• **NITTA Yoshikazu**
**Atsugi-shi, Kanagawa 243-0014 (JP)**

(74) Representative: **Müller Hoffmann & Partner**
**Patentanwälte mbB**
**St.-Martin-Straße 58**
**81541 München (DE)**

(56) References cited:
WO-A1-2011/036708    CN-A- 102 386 268
JP-A- H08 122 143    JP-A- H08 122 144
JP-A- 2000 146 686    JP-A- 2002 296 117
JP-A- 2002 296 117    JP-A- 2007 333 558
JP-A- 2008 204 978    JP-A- 2009 133 825
JP-A- 2009 156 614    JP-A- 2010 276 516
JP-A- 2011 169 857    JP-A- 2012 154 762
JP-A- 2018 040 791    JP-A- 2018 040 791
US-A1- 2003 057 372    US-A1- 2009 146 059
US-A1- 2015 357 361    US-A1- 2016 091 371
US-A1- 2018 143 078

• TOHYAMA SHIGERU ET AL: "Uncooled infrared
detectors toward smaller pixel pitch with newly
proposed pixel structure", INFRARED
TECHNOLOGY AND APPLICATIONS XXXVII,
SPIE, 1000 20TH ST. BELLINGHAM WA
98225-6705 USA, vol. 8012, no. 1, 13 May 2011
(2011-05-13) , pages 1-13, XP060016869, DOI:
10.1117/12.886345 [retrieved on 1901-01-01]

**Description**

TECHNICAL FIELD

The present disclosure relates to an imaging device, and more specifically, to an imaging device including a temperature detection element that detects a temperature on the basis of infrared rays.

BACKGROUND ART

As a thermal infrared detection device, from, for example, Japanese Patent Application Laid-Open No. 2007-171170, a thermal infrared detection device is known that includes: a thermal infrared detection element that is formed by using a wafer, and in which an infrared detection unit thermally insulated from the surroundings is formed on one surface side; and a package sealed to a thermal infrared detection element to surround the infrared detection unit on the one surface side of the thermal infrared detection element.

Further imaging devices are known from JP 2018 040791 A, JP 2002 296117 A, US 2018/143078 A1, US 2009/146059 A1, US 2003/057372 A1, and US 2015/357361 A1.

CITATION LIST

PATENT DOCUMENT

Patent Document 1: Japanese Patent Application Laid-Open No. 2007-171170

SUMMARY OF THE INVENTION

PROBLEMS TO BE SOLVED BY THE INVENTION

By the way, when the conventional thermal infrared detection element is miniaturized, the following problems may occur. That is, it is necessary to suppress an increase in time required to read a signal even in a case where the number of elements is increased by miniaturizing the thermal infrared detection element, but, in the conventional thermal infrared detection device, it is difficult to suppress the increase in the time required to read the signal due to the structure, as described later. Furthermore, when the thermal infrared detection element is miniaturized, there is also a problem that variations in read signals increase. Moreover, the infrared detection unit needs to be thermally insulated from the surroundings, but when the thermal infrared detection element is miniaturized, a region of the thermal infrared detection element for thermal insulation decreases, and, as a result, there is a problem that heat insulation from the surroundings is insufficient and the sensitivity is lowered. Furthermore, there is a demand for providing an imaging device having a configuration and a structure capable of knowing a polarization state of infrared rays. Moreover, there is a demand for a configuration and a structure for reducing variations in temperature detection depending on an arrangement position of temperature detection elements in an imaging device including a temperature detection element array in which the temperature detection elements are arranged in a two-dimensional matrix.

Thus, a first object of the present disclosure is to provide an imaging device having a configuration and a structure that can be miniaturized and including a temperature detection element that detects a temperature on the basis of infrared rays. Furthermore, a second object of the present disclosure is to provide an imaging device having a configuration and a structure capable of knowing a polarization state of infrared rays. Moreover, a third object of the present disclosure is to provide an imaging device in which variations are small in temperature detection depending on an arrangement position of temperature detection elements.

SOLUTIONS TO PROBLEMS

The above objects are achieved by the claimed matter according to the independent claims.

An imaging device according to a first aspect of the present disclosure for achieving the first object described above includes:

　　a plurality of temperature detection element units arranged along a first direction and a second direction different from the first direction; and
　　a plurality of infrared absorption layer units arranged along the first direction and the second direction, in which each of the temperature detection element units includes a first temperature detection element and a second temperature detection element adjacent to each other along the first direction,

each of the infrared absorption layer units includes a first infrared absorption layer and a second infrared absorption layer adjacent to each other along the second direction,

the first temperature detection element includes a first A region, and a first B region in contact with the first A region along the second direction,

the second temperature detection element includes a second A region, and a second B region in contact with the second A region along the second direction,

the first infrared absorption layer is arranged apart from the first A region and the second A region along an infrared incident direction, and is thermally connected to the first temperature detection element, and

the second infrared absorption layer is arranged apart from the first B region and the second B region along the infrared incident direction, and is thermally connected to the second temperature detection element.

An imaging device according to a second aspect of the present disclosure for achieving the first object described above includes

a plurality of temperature detection element units arranged along a first direction and a second direction different from the first direction, in which

each of the temperature detection element units includes a temperature detection element and a gain measuring element adjacent to each other along any one of the first direction and the second direction,

an infrared absorption layer is arranged apart from the temperature detection element and the gain measuring element along an infrared incident direction, and

the infrared absorption layer is thermally connected to the temperature detection element and is not thermally connected to the gain measuring element.

An imaging device according to a third aspect of the present disclosure for achieving the first object described above includes:

a plurality of temperature detection element units arranged each including two or more temperature detection elements; and

infrared absorption layers arranged apart from the respective temperature detection elements along an infrared incident direction and thermally connected to the temperature detection elements, in which

in the temperature detection element units, sizes of orthographic images of the infrared absorption layers are different for each of the temperature detection elements.

The imaging device according to a fourth aspect of the present disclosure for achieving the second object described above includes:

a plurality of temperature detection element units arranged along a first direction and a second direction different from the first direction; and

a plurality of infrared absorption layer units arranged along the first direction and the second direction, in which

each of the temperature detection element units includes a first temperature detection element unit and a second temperature detection element unit arranged together with the first temperature detection element unit along the first direction,

each of the first temperature detection element unit and the second temperature detection element unit includes a plurality of temperature detection elements arranged along the first direction and the second direction,

each of the infrared absorption layer units includes a first infrared absorption layer unit arranged apart from the first temperature detection element unit along an infrared incident direction, and a second infrared absorption layer unit arranged apart from the second temperature detection element unit along the infrared incident direction,

the first infrared absorption layer unit includes a plurality of infrared absorption layers extending along the second direction and arranged side by side along the first direction,

one of the temperature detection elements constituting the first temperature detection element unit is thermally connected to one of the infrared absorption layers constituting the first infrared absorption layer unit,

the second infrared absorption layer unit includes a plurality of infrared absorption layers extending along the first direction and arranged side by side along the second direction, and

one of the temperature detection elements constituting the second temperature detection element unit is thermally connected to one of the infrared absorption layers constituting the second infrared absorption layer unit.

An imaging device according to a fifth aspect of the present disclosure for achieving the third object described above includes:

a temperature detection element array including a plurality of temperature detection elements arranged along a first direction and a second direction different from the first direction, and

infrared absorption layers arranged apart from the respective temperature detection elements along an infrared incident direction and thermally connected to the temperature detection elements, in which

a distance from an orthographic image of the center of each of the temperature detection elements to an orthographic image of the center of each of the infrared absorption layers is longer in the temperature detection element positioned in a peripheral portion of the temperature detection element array than in the temperature detection element positioned in a central portion of the temperature detection element array.

An imaging device according to a sixth aspect of the present disclosure for achieving the third object described above includes:

a temperature detection element array including a plurality of temperature detection elements arranged along a first direction and a second direction different from the first direction, and

infrared absorption layers arranged apart from the respective temperature detection elements along an infrared incident direction and thermally connected to the temperature detection elements, in which

a size of each of the infrared absorption layers is larger in the temperature detection elements positioned in a peripheral portion of the temperature detection element array than in the temperature detection elements positioned in a central portion of the temperature detection element array.

BRIEF DESCRIPTION OF DRAWINGS

Figs. 1A and 1B are, respectively, a diagram schematically illustrating an arrangement state of temperature detection elements and a diagram schematically illustrating configurations of the temperature detection elements, in an imaging device of Example 1.

Fig. 2 is an enlarged diagram schematically illustrating the configurations of the temperature detection elements.

Fig. 3 is a diagram schematically illustrating arrangements of temperature detection element units and infrared absorption layer units in the imaging device of Example 1.

Figs. 4A and 4B are diagrams schematically illustrating an arrangement relationship among the temperature detection elements, signal lines, and drive lines in the imaging device of Example 1 and a conventional imaging device, respectively.

Fig. 5 is a diagram schematically illustrating an arrangement state of the temperature detection elements in a modification of the imaging device of Example 1.

Figs. 6A and 6B are, respectively, a diagram schematically illustrating an arrangement state of the temperature detection elements and a diagram schematically illustrating configurations of the temperature detection elements, in an imaging device of Example 2.

Fig. 7 is a diagram schematically illustrating arrangements of temperature detection element units and infrared absorption layer units in the imaging device of Example 2.

Fig. 8 is a diagram schematically illustrating the arrangements of the temperature detection element units and the infrared absorption layer units in a modification of the imaging device of Example 2.

Fig. 9 is a diagram schematically illustrating an arrangement state of the temperature detection elements in an imaging device of Example 3.

Fig. 10 is a diagram schematically illustrating an arrangement state of the temperature detection elements in a modification of the imaging device of Example 3.

Fig. 11 is a diagram schematically illustrating an arrangement state of the temperature detection elements in an imaging device of Example 4.

Fig. 12 is a diagram schematically illustrating an arrangement state of the temperature detection elements in a modification of the imaging device of Example 4.

Fig. 13 is a diagram schematically illustrating an arrangement state of temperature detection elements in an imaging device of Example 5.

Fig. 14 is a diagram schematically illustrating an arrangement state of the temperature detection elements in a modification (Modification-1) of the imaging device of Example 5.

Fig. 15 is a diagram schematically illustrating an arrangement state of temperature detection elements in a modification (Modification-2) of the imaging device of Example 5.

Fig. 16 is a diagram schematically illustrating an arrangement state of temperature detection elements in a modification (Modification-3) of the imaging device of Example 5.

Fig. 17 is a diagram schematically illustrating configurations of the temperature detection elements in modifications (Modification-2, Modification-3) of the imaging device of Example 5.

Fig. 18 is a diagram schematically illustrating an arrangement state of temperature detection elements in a modification (Modification-4) of the imaging device of Example 5.

Fig. 19 is a diagram schematically illustrating an arrangement state of the temperature detection elements in a modification (Modification-5) of the imaging device of Example 5.

Fig. 20 is a diagram schematically illustrating arrangements of temperature detection element units and infrared absorption layer units in the modification (Modification-5) of the imaging device of Example 5.

Fig. 21 is a diagram schematically illustrating arrangements of temperature detection element units and infrared absorption layer units in a modification (Modification-6) of the imaging device of Example 5.

Fig. 22 is a diagram schematically illustrating an arrangement state of temperature detection elements in an imaging device of Example 6.

Fig. 23 is a diagram schematically illustrating an arrangement state of the temperature detection elements in a modification of the imaging device of Example 6.

Fig. 24 is a diagram schematically illustrating an arrangement state of temperature detection elements in an imaging device of Example 7.

Fig. 25 is a diagram schematically illustrating an arrangement state of temperature detection elements in an imaging device of Example 8.

Fig. 26 is a diagram schematically illustrating an arrangement state of temperature detection elements in an imaging device of Example 9.

Fig. 27 is a schematic partial end view of a temperature detection element, an infrared absorption layer, and the like in an imaging device of Example 10.

Fig. 28 is a schematic exploded perspective view of a first structural body and a second structural body in the imaging device of Example 10.

Fig. 29 is an equivalent circuit diagram of the imaging device of Example 10.

Fig. 30 is a schematic partial end view of a temperature detection element, an infrared absorption layer, and the like in a modification of the imaging device of Example 10.

Fig. 31 is a diagram schematically illustrating an arrangement state of temperature detection elements in yet another modification of the imaging device of Example 5.

Fig. 32 is a conceptual diagram of an infrared camera including the imaging device of the present disclosure.

Figs. 33A, 33B, 33C, and 33D are schematic partial end views of an SOI substrate and the like for explaining a method of manufacturing the imaging device of Example 10.

Figs. 34A, 34B, and 34C are schematic partial end views of the SOI substrate and the like for explaining the method of manufacturing the imaging device of Example 10, following Fig. 33D.

Figs. 35A and 35B are schematic partial end views of the SOI substrate and the like for explaining the method of manufacturing the imaging device of Example 10, following Fig. 34C.

Figs. 36A and 36B are schematic partial end views of the SOI substrate and the like for explaining the method of manufacturing the imaging device of Example 10, following Fig. 35B.

MODE FOR CARRYING OUT THE INVENTION

Hereinafter, the present disclosure will be described on the basis of examples with reference to the drawings, but the present disclosure is not limited to the examples, and various numerical values and materials in the examples are exemplifications. Note that, description will be given in the following order.

1. General description of imaging device according to first to sixth aspects of present disclosure
2. Example 1 (imaging device according to first aspect of present disclosure)
3. Example 2 (modification of Example 1)
4. Example 3 (modification of Examples 1 to 2)
5. Example 4 (modification of Example 3)
6. Example 5 (imaging device according to second aspect of present disclosure)
7. Example 6 (imaging device according to third aspect of present disclosure)
8. Example 7 (imaging device according to fourth aspect of present disclosure)
9. Example 8 (imaging device according to fifth aspect of present disclosure)
10. Example 9 (imaging device according to sixth aspect of present disclosure)
11. Example 10 (details of imaging device described in Examples 1 to 9)
12. Example 11 (application example of imaging device of present disclosure)
13. Others

<General description of imaging device according to first to sixth aspects of the present disclosure>

In an imaging device according to a first aspect of the present disclosure, a mode can be made in which

an orthographic image of the first infrared absorption layer overlaps at least a part of the first A region and a part of the second A region, and
an orthographic image of the second infrared absorption layer overlaps at least a part of the first B region and a part of the second B region. Then, in this case, a mode can be made in which
the orthographic image of the first infrared absorption layer overlaps the first A region and the second A region, and
the orthographic image of the second infrared absorption layer overlaps the first B region and the second B region.

In the imaging device according to the first aspect of the present disclosure including the preferable modes described above, a configuration can be made in which the first infrared absorption layer and the second infrared absorption layer coat the first temperature detection element and the second temperature detection element substantially without a gap. Here, "coat the first temperature detection element and the second temperature detection element substantially without a gap" means that a gap is formed for separating the first infrared absorption layer and the second infrared absorption layer from each other, but a planar shape of a portion of the first infrared absorption layer facing the second infrared absorption layer and a planar shape of a portion of the second infrared absorption layer facing the first infrared absorption layer have complementary shapes. The same applies to the following description.

Alternatively, in the imaging device according to the first aspect of the present disclosure including the preferable modes described above, a configuration can be made in which a gain measuring element is arranged between the temperature detection element units. Then, in this case, a configuration can be made in which the first infrared absorption layer and the second infrared absorption layer coat the first temperature detection element and the second temperature detection element substantially without a gap, and does not coat the gain measuring element, or alternatively, the first infrared absorption layer and the second infrared absorption layer coat the first temperature detection element, the second temperature detection element, and the gain measuring element substantially without a gap. Here, "coat the first temperature detection element, the second temperature detection element, and the gain measuring element substantially without a gap" means that a gap is formed for separating the first infrared absorption layer and the second infrared absorption layer from each other, but a planar shape of a portion of the first infrared absorption layer facing the second infrared absorption layer and a planar shape of a portion of the second infrared absorption layer facing the first infrared absorption layer have complementary shapes. The same applies to the following description.

In an imaging device according to a second aspect of the present disclosure, a mode can be made in which

the infrared absorption layer includes a first infrared absorption layer and a second infrared absorption layer,
an orthographic image of the first infrared absorption layer overlaps the temperature detection element and the gain measuring element,
an orthographic image of the second infrared absorption layer overlaps the temperature detection element and the gain measuring element,
the first infrared absorption layer is thermally connected to the temperature detection element and is not thermally connected to the gain measuring element, and
the second infrared absorption layer is thermally connected to the temperature detection element and is not thermally connected to the gain measuring element. Then, in this case, a mode can be made in which
the temperature detection element and the gain measuring element are adjacent to each other along the second direction,
the temperature detection element unit further includes a temperature detection element-A and a temperature detection element-B,
the temperature detection element and the temperature detection element-A are arranged along the first direction,
the gain measuring element and the temperature detection element-B are arranged along the first direction,
an infrared absorption layer-A and an infrared absorption layer-B are arranged apart from the temperature detection element-A and the temperature detection element-B along the infrared incident direction,
the infrared absorption layer-A is arranged apart from the infrared absorption layer-B along the second direction,
the infrared absorption layer-A is thermally connected to the temperature detection element-A, and
the infrared absorption layer-B is thermally connected to the temperature detection element-B.

Alternatively, in the imaging device according to the second aspect of the present disclosure, a mode can be made in which

the infrared absorption layer includes a first infrared absorption layer and a second infrared absorption layer,

an orthographic image of the first infrared absorption layer overlaps the temperature detection element and the gain measuring element,

an orthographic image of the second infrared absorption layer overlaps the temperature detection element and the gain measuring element,

the first infrared absorption layer is thermally connected to the temperature detection element and is not thermally connected to the gain measuring element, and

the second infrared absorption layer is not thermally connected to the temperature detection element and is not thermally connected to the gain measuring element. Then, in this case, a mode can be made in which

the temperature detection element and the gain measuring element are adjacent to each other along the second direction,

the temperature detection element unit further includes a temperature detection element-A and a temperature detection element-B,

the temperature detection element and the temperature detection element-A are arranged along the first direction,

the gain measuring element and the temperature detection element-B are arranged along the first direction,

an infrared absorption layer-A and an infrared absorption layer-B are arranged apart from the temperature detection element-A and the temperature detection element-B along the infrared incident direction,

the infrared absorption layer-A is arranged apart from the infrared absorption layer-B along the second direction,

the infrared absorption layer-A is thermally connected to the temperature detection element-A, and

the infrared absorption layer-B is thermally connected to the temperature detection element-B.

In an imaging device according to a fourth aspect of the present disclosure, a mode can be made in which the first temperature detection element unit and the second temperature detection element unit are arranged in a checkerboard pattern along the first direction and the second direction.

Then, in the imaging device according to the fourth aspect of the present disclosure including the preferable modes described above, a mode can be made in which

the first temperature detection element unit includes a first temperature detection element and a second temperature detection element arranged along the first direction, and, along the second direction, a third temperature detection element arranged adjacent to the first temperature detection element, and a fourth temperature detection element arranged adjacent to the second temperature detection element,

the second temperature detection element unit includes a fifth temperature detection element and a sixth temperature detection element arranged along the first direction, and, along the second direction, a seventh temperature detection element arranged adjacent to the fifth temperature detection element, and an eighth temperature detection element arranged adjacent to the sixth temperature detection element,

the first temperature detection element includes a first A region, and a first B region in contact with the first A region along the second direction,

the second temperature detection element includes a second A region, and a second B region in contact with the second A region along the second direction,

the third temperature detection element includes a third A region, and a third B region in contact with the third A region along the second direction,

the fourth temperature detection element includes a fourth A region, and a fourth B region in contact with the fourth A region along the second direction,

the fifth temperature detection element includes a fifth A region, and a fifth B region in contact with the fifth A region along the first direction,

the sixth temperature detection element includes a sixth A region, and a sixth B region in contact with the sixth A region along the first direction,

the seventh temperature detection element includes a seventh A region, and a seventh B region in contact with the seventh A region along the first direction,

the eighth temperature detection element includes an eighth A region, and an eighth B region in contact with the eighth A region along the first direction,

the first infrared absorption layer unit includes a first infrared absorption layer, a second infrared absorption layer, a third infrared absorption layer, and a fourth infrared absorption layer,

the second infrared absorption layer unit includes a fifth infrared absorption layer, a sixth infrared absorption layer, a seventh infrared absorption layer, and an eighth infrared absorption layer,

the first infrared absorption layer is arranged apart from the first A region and the second A region along the infrared incident direction, and is thermally connected to the first temperature detection element,

the second infrared absorption layer is arranged apart from the first B region and the second B region along the infrared incident direction, and is thermally connected to the second temperature detection element,

the third infrared absorption layer is arranged apart from the third A region and the fourth A region along the infrared incident direction, and is thermally connected to the third temperature detection element,

the fourth infrared absorption layer is arranged apart from the third B region and the fourth B region along the infrared incident direction, and is thermally connected to the fourth temperature detection element,

the fifth infrared absorption layer is arranged apart from the fifth A region and the sixth A region along the infrared incident direction, and is thermally connected to the fifth temperature detection element,

the sixth infrared absorption layer is arranged apart from the fifth B region and the sixth B region along the infrared incident direction, and is thermally connected to the sixth temperature detection element,

the seventh infrared absorption layer is arranged apart from the seventh A region and the eighth A region along the infrared incident direction, and is thermally connected to the seventh temperature detection element, and

the eighth infrared absorption layer is arranged apart from the seventh B region and the eighth B region along the infrared incident direction, and is thermally connected to the eighth temperature detection element.

As the planar shape of the first infrared absorption layer and the second infrared absorption layer, a quadrangle including a rectangle such as a square or an oblong, a rhombus, a polygon (for example, a hexagon), and a combination of polygons (for example, a combination of an octagon and a quadrangle) can be mentioned, and as the infrared absorption layer, a quadrangle including a rectangle such as a square or an oblong, a rhombus, a polygon (for example, a hexagon), and a combination of polygons (for example, a combination of an octagon and a quadrangle) can also be mentioned.

In the imaging devices according to the first to sixth aspects of the present disclosure including the various preferable modes and configurations described above (hereinafter, these may be collectively referred to as "imaging device and the like of the present disclosure"), a mode can be made in which the temperature detection element includes: various diodes such as pn junction diodes including SOI diodes and Schottky diodes, or combinations of transistors, diodes, and active elements; a resistance bolometer element including vanadium oxide film, amorphous silicon film, polysilicon film, silicon carbide film, titanium film, or the like; a thermoelectric conversion element using a metal such as platinum, gold, or nickel, a thermistor, or the like; a thermopile element using Seebeck effect; pyroelectric element in which the surface charge of the dielectric changes; a ferroelectric element; a diode using tunnel effect; or an element applying superconductivity, and these have known structures and configurations. More specifically, a mode can be made in which the temperature detection element includes a pn junction diode, a bolometer element, a thermopile element, a metal film resistance element, a metal oxide resistance element, a ceramic resistance element, or a thermistor element. One temperature detection element can include, for example, a plurality of diodes connected together in series. The temperature detection element can be formed on the basis of, for example, so-called MEMS technology.

As the number of a plurality of temperature detection elements that is arranged in the first direction and the second direction different from the first direction (specifically, for example, in a two-dimensional matrix) and that detects a temperature on the basis of infrared rays, or as the temperature detection element units, numbers can be exemplified such as $640 \times 480$ (VGA), $320 \times 240$ (QVGA), $160 \times 120$ (QQVGA), $612 \times 512$, $1980 \times 1080$ (and its integral multiples), and $2048 \times 1080$ (and its integral multiples). The first direction and the second direction are preferably orthogonal to each other, but not limited to this, and in the pixel array of the number of pixels described above, an array may be formed in which the pixels are removed in a checkerboard pattern and rotated by 45 degrees diagonally.

The infrared absorption layer is formed on a side on which infrared rays are incident, or on an opposite side from the side on which the infrared rays are incident, with the temperature detection element as a reference. The infrared absorption layer is arranged apart from the temperature detection element along the infrared incident direction, and when a virtual plane including the infrared absorption layer is an XY plane, the infrared absorption layer is formed apart from the temperature detection element in the +Z direction (an opposite direction from a direction in which the infrared rays enter, upward direction) or in the -Z direction (the same direction as the direction in which the infrared rays enter, downward direction). The infrared absorption layer may be formed in a state where a gap (space) exists between the infrared absorption layer and the temperature detection element, or the infrared absorption layer may be formed on an insulating film formed on the temperature detection element.

As a material forming the infrared absorption layer, materials can be exemplified such as chromium (Cr) and its alloys, aluminum (Al) and its alloys, gold (Au) and its alloys, silver (Ag) and its alloys, copper (Cu) and its alloys, platinum (Pt) and its alloys, or a laminated structure of a layer including these materials and, for example, a $SiO_2$ film or a SiN film. It is desirable that heat generated as a result of absorption of infrared rays in the infrared absorption layer is reliably transferred to the temperature detection element. Furthermore, the infrared absorption layer is preferably set to have a thickness such that a sheet resistance value of a conductor material or the resistor material forming the infrared absorption layer is in a range of $377\ \Omega\square \pm 30\%$, for example. As a material forming an infrared reflection layer described later, materials can be exemplified that have characteristics (for example, area resistivity, sheet resistance value) different from those of the infrared absorption layer, such as aluminum (Al) and its alloys, gold (Au) and its alloys, silver (Ag) and its alloys, copper (Cu) and its alloys, platinum (Pt) and its alloys, or a laminated structure of layers including these materials.

It is preferable that a void is formed below the temperature detection element, and the temperature detection element is in a state of being supported by two support portions and floating in the air. That is, a mode can be made in which: the temperature detection element is arranged above the void provided on a first substrate; a first connection portion provided on the first substrate and a first terminal portion of the temperature detection element are connected together via a first stud portion (support leg or elongated beam, the same applies below); a second connection portion provided on the first substrate and a second terminal portion of the temperature detection element are connected together via a second stud portion. A mode can also be made in which the void is shared by a plurality of adjacent temperature detection elements.

Furthermore, a configuration can be made in which the infrared reflection layer is formed on the bottom of the void. The infrared reflection layer is preferably formed on all or part of the bottom of the void. A configuration can be made in which

when a wavelength of infrared rays to be absorbed by the infrared absorption layer is $\lambda_{IR}$, an optical distance $L_0$ between the infrared absorption layer and the infrared reflection layer (distance in consideration of the thickness and refractive index of the material) satisfies

$$0.75 \times \lambda_{IR}/2 \leq L_0 \leq 1.25 \times \lambda_{IR}/2$$

or

$$0.75 \times \lambda_{IR}/4 \leq L_0 \leq 1.25 \times \lambda_{IR}/4.$$

As $\lambda_{IR}$, 8 $\mu$m to 14 $\mu$m can be exemplified.

In a case where the infrared absorption layer is formed on the side on which infrared rays are incident with the temperature detection element as a reference, a configuration can also be made in which a lower infrared absorption layer is formed on a side of the temperature detection element facing the void. The lower infrared absorption layer is only required to be formed, for example, on a surface of the temperature detection element facing the void, or may be formed on an insulating film formed on the surface of the temperature detection element facing the void, or the lower infrared absorption layer may be formed in a state where a gap (space) exists between the lower infrared absorption layer and the temperature detection element. Since each infrared absorption layer not only absorbs infrared rays but also partially transmits and partially reflects the infrared rays, the sensitivity can be further improved by adopting a structure that reduces transmission and reflection. That is, with such a configuration, a part of the infrared rays transmitted through the infrared absorption layer are further absorbed by the lower infrared absorption layer, so that the transmission can be reduced. Furthermore, the infrared rays reflected by the infrared absorption layer and the infrared rays reflected by the lower infrared absorption layer have opposite phases and cancel each other out, and the reflection can be reduced. Furthermore, the infrared rays reflected by the lower infrared absorption layer and the infrared rays reflected by the infrared reflection layer have opposite phases and cancel each other out, and the reflection can be reduced. Moreover, in these cases, a configuration can be made in which when the wavelength of infrared rays to be absorbed by the infrared absorption layer and the lower infrared absorption layer is $\lambda_{IR}$, and an optical distance between the infrared absorption layer and the lower infrared absorption layer is $L_1$, and an optical distance between the lower infrared absorption layer and the infrared reflection layer is $L_2$,

$$0.75 \times \lambda_{IR}/4 \leq L_1 \leq 1.25 \times \lambda_{IR}/4$$

$$0.75 \times \lambda_{IR}/4 \leq L_2 \leq 1.25 \times \lambda_{IR}/4$$

are satisfied. As $\lambda_{IR}$, 8 um to 14 um can be exemplified.

A configuration can be made in which each of signal lines is connected to an analog front end and an analog-digital conversion circuit, and the analog front end includes a differential integration circuit that functions as an amplifier (preamplifier). Then, a mode can be made in which a switch means for controlling a conductive state between the differential integration circuit and the signal line is provided between the differential integration circuit and the signal line, and, moreover, in this case, a mode can be made in which the switch means sets the signal line to a fixed potential when setting a non-conductive state between the differential integration circuit and the signal line. The switch means, the analog-digital conversion circuit, and the analog front end including the differential integration circuit can have known circuit configurations.

In the imaging device and the like of the present disclosure, the first substrate can include, for example, a silicon semiconductor substrate or an SOI substrate, and a second substrate described later can include, for example, a silicon semiconductor substrate. Drive lines and the signal lines are only required to be formed on the basis of a known method from a known conductive material. A drive circuit included in the second substrate can also include a known drive circuit. Alternatively, the drive circuit can include a known readout integrated circuit (ROIC).

As a method of electrically connecting the drive lines and the signal lines to the drive circuit, methods can be exemplified such as: a method using a bump containing solder, indium, gold (Au), or the like; a method based on a chip-on-chip system; a method using a through chip via (TCV) or a through silicon via (TSV); and metal-metal bonding including Cu-Cu.

The drive circuit provided on the second substrate is preferably coated with a coating layer. That is, the top surface of the second substrate is preferably coated with the coating layer. The coating layer is exposed at the bottom of the void. The coating layer can include, for example, a silicon oxide-based material, a silicon nitride-based material, a silicon oxynitride-based material, or various organic materials. The coating layer may have a single-layer configuration, or may have a laminated structure of a plurality of layers. The infrared reflection layer may be provided on the coating layer, or may be provided inside the coating layer.

It is preferable that a space in which the temperature detection element is arranged is decompressed and is made to be in a vacuum (including a low pressure close to the vacuum, and the same applies below). It is preferable that the void is also decompressed and made to be in a vacuum. Alternatively, it is preferable that the entire imaging device is stored in a package or container (case) decompressed and made to be in a vacuum.

Moreover, a configuration can be made in which a protective substrate is arranged on the side on which infrared rays are incident. As a material forming the protective substrate, materials can be exemplified such as a silicon semiconductor substrate, a quartz substrate, a plastic substrate, a plastic film, a germanium substrate, and a substrate including a material (specifically, $CaF_2$, $BaF_2$, $Al_2O_3$, ZnSe, or the like) that transmits infrared rays. Furthermore, as the plastic, polyethylene can be exemplified.

If necessary, the imaging device on the infrared incident side may be provided with a structure for preventing reflection of infrared rays, an infrared filter for causing only infrared rays of a specific frequency to pass through, and a light focusing element such as a diffraction grating or a lens.

The imaging device and the like of the present disclosure can be applied to, for example, an infrared camera, a night-vision camera, a thermograph, an in-vehicle camera (human detection), an air conditioner (human detection sensor), and a microwave oven. Note that, in some cases, the imaging device and the like of the present disclosure can also be referred to as a temperature detection sensor that detects a temperature on the basis of infrared rays.

[Example 1]

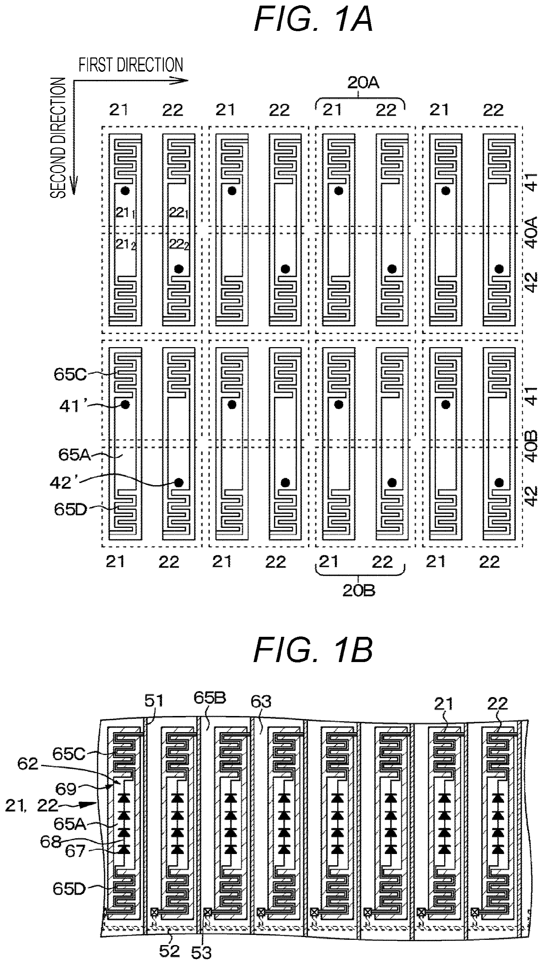

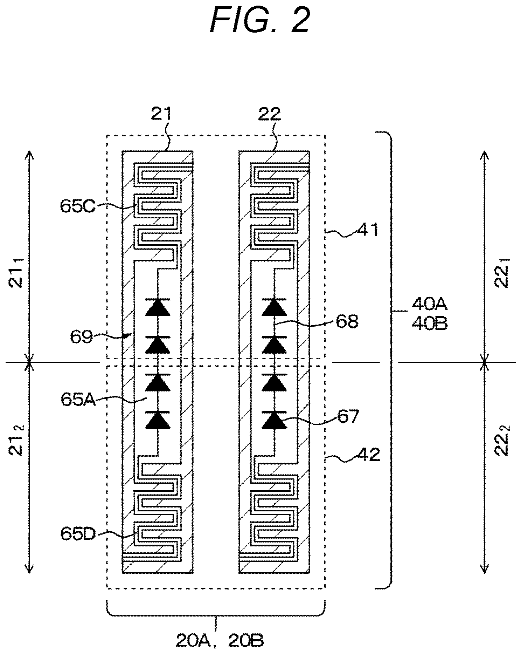

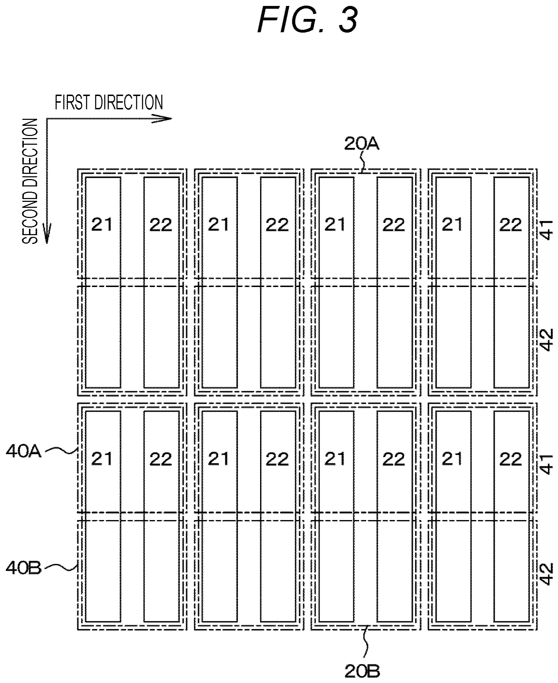

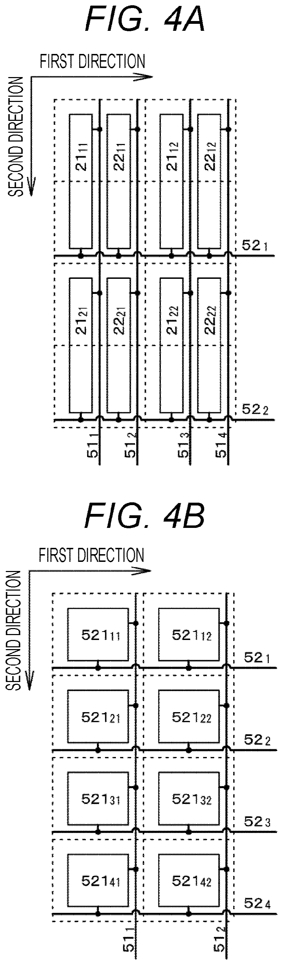

Example 1 relates to the imaging device according to the first aspect of the present disclosure. An arrangement state of temperature detection elements in an imaging device of Example 1 is schematically illustrated in Fig. 1A, configurations of the temperature detection elements are schematically illustrated in Figs. 1B and 2, arrangements of temperature detection element units and infrared absorption layer units are schematically illustrated in Fig. 3, and arrangement relationships among the temperature detection elements, the signal lines, and the drive lines in the imaging device of Example 1 and a conventional imaging device are schematically illustrated in Figs. 4A and 4B, respectively.

The imaging device of Example 1 includes:

a plurality of temperature detection element units 20A and 20B arranged along a first direction and a second direction different from the first direction; and

a plurality of infrared absorption layer units 40A and 40B arranged along the first direction and the second direction, in which

each of the temperature detection element units 20A and 20B includes a first temperature detection element 21 and a second temperature detection element 22 adjacent to each other along the first direction,

each of the infrared absorption layer units 40A and 40B includes a first infrared absorption layer 41 and a second infrared absorption layer 42 adjacent to each other along the second direction,

the first temperature detection element 21 includes a first A region $21_1$, and a first B region $21_2$ in contact with the first A region $21_1$ along the second direction,

the second temperature detection element 22 includes a second A region $22_1$, and a second B region $22_2$ in contact with the second A region $22_1$ along the second direction,

the first infrared absorption layer 41 is arranged apart from the first A region $21_1$ and the second A region $22_1$ along an infrared incident direction, and is thermally connected to the first temperature detection element 21, and

the second infrared absorption layer 42 is arranged apart from the first B region $21_2$ and the second B region $22_2$ along the infrared incident direction, and is thermally connected to the second temperature detection element 22.

Then, in the imaging device of Example 1,

an orthographic image of the first infrared absorption layer 41 overlaps at least a part of the first A region $21_1$ and a part of the second A region $22_1$, and
an orthographic image of the second infrared absorption layer 42 overlaps at least a part of the first B region $21_2$ and a part of the second B region $22_2$. Specifically,
the orthographic image of the first infrared absorption layer 41 overlaps the first A region $21_1$ and the second A region $22_1$, and
the orthographic image of the second infrared absorption layer 42 overlaps the first B region $21_2$ and the second B region $22_2$.

The first infrared absorption layer 41 and the second infrared absorption layer 42 are arranged above (+Z direction) the first temperature detection element 21 and the second temperature detection element 22. Furthermore, the first infrared absorption layer 41 is thermally connected to the first temperature detection element 21 at a connection portion 41', and the second infrared absorption layer 42 is thermally connected to the second temperature detection element 22 at a connection portion 42'. In Fig. 1A, the first infrared absorption layer 41 and the second infrared absorption layer 42 are illustrated surrounded by a dotted line, and in Fig. 3, the temperature detection element unit 20A and the temperature detection element unit 20B are illustrated surrounded by a one-dot chain line, and the infrared absorption layer unit 40A and the infrared absorption layer unit 40B are illustrated surrounded by a two-dot chain line.

Furthermore, the first infrared absorption layer 41 and the second infrared absorption layer 42 coat the first temperature detection element 21 and the second temperature detection element 22 substantially without a gap. Specifically, a gap is formed for separating the first infrared absorption layer 41 and the second infrared absorption layer 42 from each other, but a planar shape of a portion of the first infrared absorption layer 41 facing the second infrared absorption layer 42 and a planar shape of a portion of the second infrared absorption layer 42 facing the first infrared absorption layer 41 have complementary shapes.

Here, when a length along the first direction of the temperature detection element units 20A and 20B is $K_{11}$, a length along the second direction of the temperature detection element units 20A and 20B is $K_{12}$, a length along the first direction of the infrared absorption layer units 40A and 40B is $K_{21}$, and a length along the second direction of the infrared absorption layer units 40A and 40B is $K_{22}$, a length along the first direction of the first temperature detection element 21 and the second temperature detection element 22 is $\alpha_{11} \times (K_{11}/2)$, a length along the second direction of the first temperature detection element 21 and the second temperature detection element 22 is $K_{12}$, a length along the first direction of the first infrared absorption layer 41 and the second infrared absorption layer 42 is $K_{21}$, and a length along the second direction of the first infrared absorption layer 41 and the second infrared absorption layer 42 is $\alpha_{22} \times (K_{22}/2)$. As values of $\alpha_{11}$ and $\alpha_{22}$,

$$0.5 \leq \alpha_{11} \leq 1.0$$

$$0.5 \leq \alpha_{22} \leq 1.0$$

can be exemplified. Furthermore, as values of $K_{21}/K_{11}$, $K_{22}/K_{12}$,

$$0.5 \leq K_{21}/K_{11} \leq 2.0$$

$$0.5 \leq K_{22}/K_{12} \leq 2.0$$

can be exemplified, but are not limited to these values and ranges.

Note that, in the drawings schematically illustrating the arrangement state of the temperature detection elements, to simplify the arrangement state, an outline of an orthographic image of the infrared absorption layer unit is illustrated to be positioned outside an outline of the temperature detection element unit; however, in practice, the outline of the infrared absorption layer unit may protrude from the temperature detection element unit ($K_{21}/K_{11} > 1$ or $K_{22}/K_{12} > 1$), the orthographic image of the infrared absorption layer unit may be positioned inside the temperature detection element unit ($K_{21}/K_{11} < 1$ and $K_{22}/K_{12} < 1$), or an orthographic image of the infrared absorption layer may coincide with the temperature detection element unit ($K_{21}/K_{11} = 1$ and $K_{22}/K_{12} = 1$).

In Example 1, the temperature detection elements 21 and 22 include a plurality (four in the illustrated example) of pn junction diodes 67 connected together in series via wiring lines 68, but this is not a limitation, and the temperature detection elements 21 and 22 can also include a resistance bolometer element, a thermoelectric conversion element, a thermopile element, a pyroelectric element, and a ferroelectric element having known configurations and structures. The pn junction diode has a known configuration and structure. The temperature detection elements 21 and 22 are formed on the basis of so-called MEMS technology as described later, and are provided on the infrared incident side of a first substrate 61 (a second surface 61B of the first substrate 61) as described later.

The temperature detection elements 21 and 22 (specifically, the pn junction diodes 67) are formed on a diaphragm portion (aerial portion, aerial thin layer portion) 65A including an insulating material layer including $SiO_2$. Furthermore, an insulating material layer 65B including $SiO_2$ is formed on the top surface of a partition wall 63 described later. The diaphragm portion 65A and the insulating material layer 65B are integrally formed via a first stud portion 65C (support leg or elongated beam. the same applies below) and a second stud portion 65D corresponding to extending portions of the diaphragm portion 65A and the insulating material layer 65B. A void 69 is positioned below the diaphragm portion 65A, the first stud portion 65C, and the second stud portion 65D. In Figs. 1B, 2, 6B, and 17, the void 69 is shaded to clearly illustrate the void 69.

One end of the temperature detection element 21 or 22 (a pn junction diode 67 positioned at one end of the plurality of pn junction diodes 67) is connected to a signal line 51 provided on the insulating material layer 65B formed above the partition wall 63 via a wiring line 68 formed on the diaphragm portion 65A and the second stud portion 65D. Furthermore, the other end of the temperature detection element 21 or 22 (a pn junction diode 67 positioned at the other end of the plurality of pn junction diodes 67) is connected to a drive line 52 formed above the partition wall 63 via a wiring line 68 formed on the diaphragm portion 65A and the first stud portion 65C, and, moreover, a contact hole 53. The diaphragm portion 65A, the first stud portion 65C, the second stud portion 65D, the pn junction diodes 67, the wiring lines 68, the signal line 51, and the drive line 52 are coated with an insulating film 66 including $SiO_2$. The drive line 52 and the signal line 51 are electrically connected to the drive circuit. The signal line 51 extends, for example, in the second direction, and the drive line 52 extends, for example, in the first direction. The signal line 51 and the drive line 52 intersect three-dimensionally. Specifically, in the illustrated example, the signal line 51 is positioned above the drive line 52.

The temperature detection elements 21 and 22 (specifically, the pn junction diodes 67) can be formed by, for example, ion implantation of n-type impurities and p-type impurities into a silicon layer, as described later. The number of the plurality of temperature detection elements 21 and 22 is, for example, $640 \times 480$ (VGA). The first direction and the second direction are orthogonal to each other.

Configurations and structures of the temperature detection elements 21 and 22 will be described in detail in Example 10, as those of a temperature detection element 15.

As illustrated in Fig. 4A schematically illustrating the arrangement relationship among the temperature detection elements, the signal lines, and the drive lines in the imaging device of Example 1, one drive line $52_1$ and four signal lines $51_1$, $51_2$, $51_3$, and $51_4$ are connected to total of four temperature detection elements 21 and 22 of two first temperature detection elements $21_{11}$ and $21_{12}$ and two second temperature detection elements $22_{11}$ and $22_{12}$. Thus, signals of these four temperature detection elements $21_{11}$, $21_{12}$, $22_{11}$, and $22_{12}$ can be read at once. On the other hand, as illustrated in Fig. 4B schematically illustrating the arrangement relationship among the temperature detection elements, the signal lines, and the drive lines in the conventional imaging device, four temperature detection elements $521_{11}$, $521_{12}$, $521_{21}$, and $521_{22}$ occupying the same area are arranged in $2 \times 2$ in the conventional imaging device. Then, two drive lines $52_1$ and $52_2$ and two signal lines $51_1$ and $51_2$ are connected to the four temperature detection elements 521. Thus, to read signals of these four temperature detection elements $521_{11}$, $521_{12}$, $521_{21}$, and $521_{22}$, two read operations are required. That is, it is possible to shorten (for example, 1/2) the time required for reading the signals in the imaging device of Example 1, compared with the time required for reading the signals in the conventional imaging device.

As described above, in the imaging device of Example 1, the first infrared absorption layer is arranged apart from (for example, above) the first A region and the second A region, and is thermally connected to the first temperature detection element, and the second infrared absorption layer is arranged apart from (for example, above) the first B region and the second B region, and is thermally connected to the second temperature detection element. Thus, it becomes possible to read the signals of the first temperature detection element and the second temperature detection element at the same time, and it is possible to suppress an increase in the time required for reading the signals, and moreover, a region (the first stud portion and the second stud portion) of the temperature detection element for heat insulation does not become small, and the sensitivity is not lowered, so that the temperature detection element can be miniaturized.

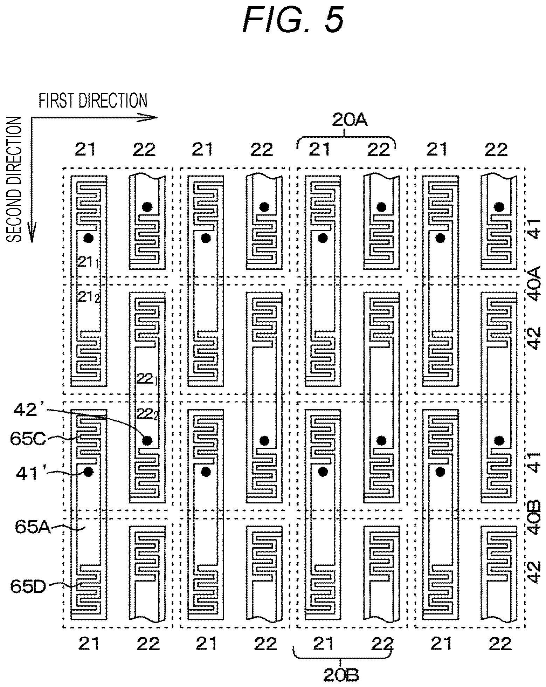

An arrangement state of the temperature detection elements in a modification of the imaging device of Example 1 is schematically illustrated in Fig. 5, and the first temperature detection element 21 and the second temperature detection element 22 may be arranged in a state of being shifted from each other along the second direction (for example, a state of being shifted from each other by 1/2 of an arrangement pitch of the temperature detection elements along the second direction).

12

[Example 2]

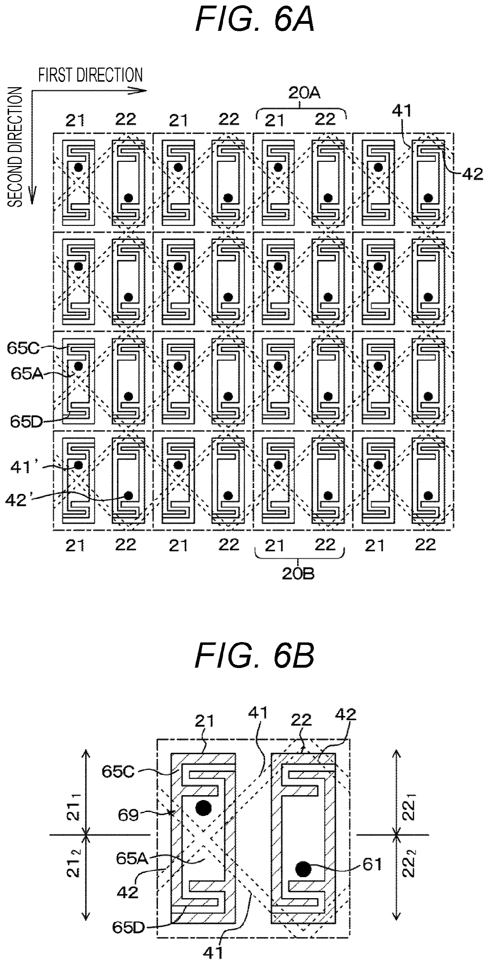

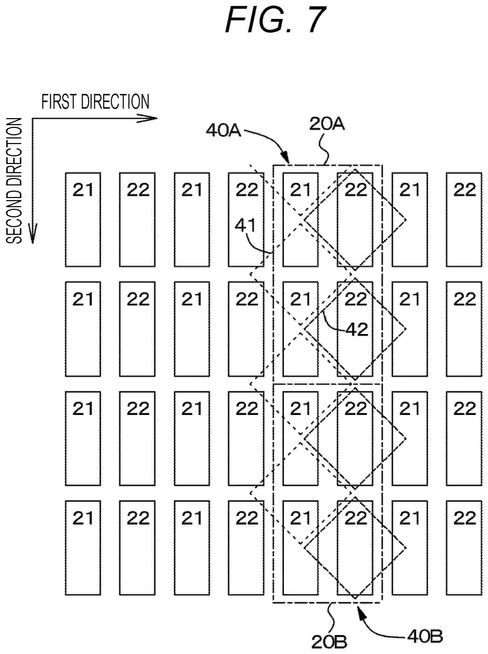

Example 2 is a modification of Example 1. As illustrated such that an arrangement state of temperature detection elements in an imaging device of Example 2 is schematically illustrated in Fig. 6A, configurations of the temperature detection elements are schematically illustrated in Fig. 6B, and arrangements of temperature detection element units and infrared absorption layer units are schematically illustrated in Fig. 7, also in the imaging device of Example 2, the orthographic image of the first infrared absorption layer 41 overlaps at least a part of the first A region $21_1$ and a part of the second A region $22_1$, and the orthographic image of the second infrared absorption layer 42 overlaps at least a part of the first B region $21_2$ and a part of the second B region $22_2$.

Note that, in Fig. 7, a part of the infrared absorption layer unit 40A and the infrared absorption layer unit 40B is illustrated, and the temperature detection element unit 20A and the temperature detection element unit 20B are illustrated surrounded by a one-dot chain line, and the infrared absorption layer unit 40A is illustrated surrounded by a dotted line, and the infrared absorption layer unit 40B is illustrated surrounded by a broken line.

Except for the above points, the configuration and structure of the imaging device of Example 2 can be made similar to the configuration and structure of the imaging device described in Example 1, and thus detailed description thereof will be omitted.

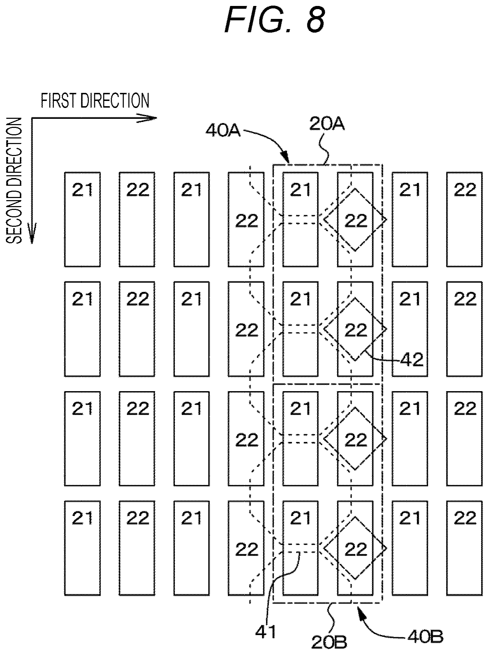

Note that, as illustrated in Fig. 8 schematically illustrating an arrangement state of the temperature detection elements in a modification of the imaging device of Example 2, the size of the first infrared absorption layer 41 and the size of the second infrared absorption layer 42 may be made different from each other, and as a result, variations can be suppressed in read signals in the temperature detection elements.

[Example 3]

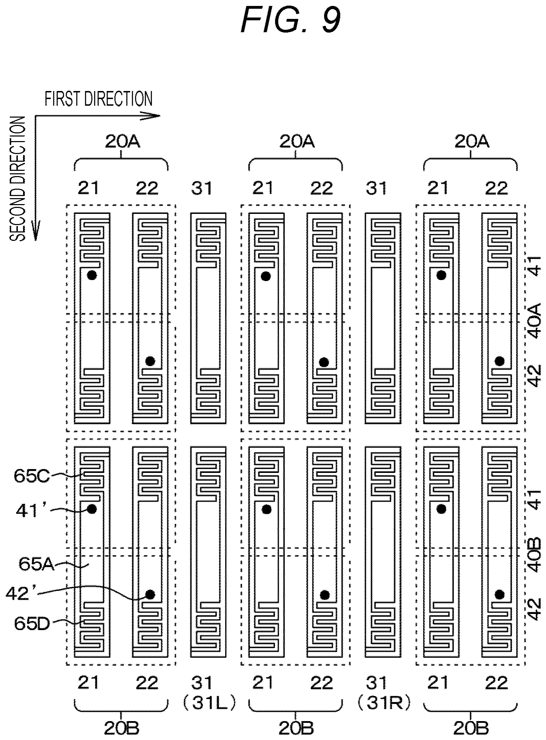

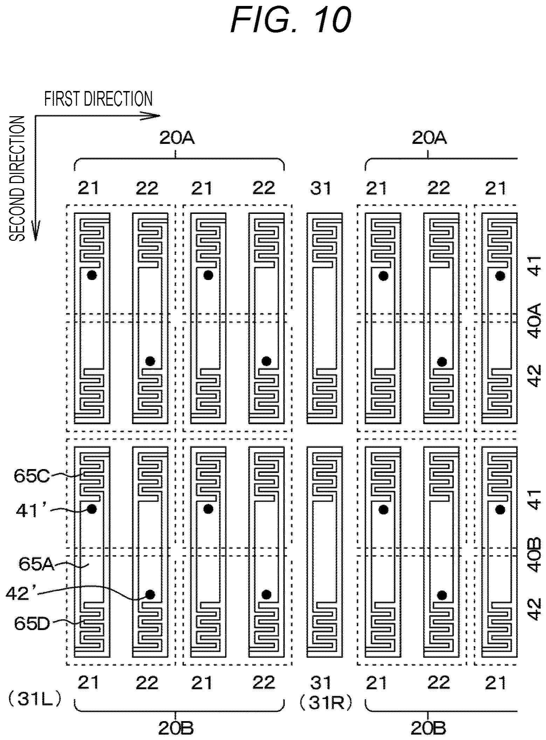

Example 3 is a modification of Examples 1 to 2. An arrangement state of the temperature detection elements in an imaging device of Example 3 is schematically illustrated in Figs. 9 and 10.

In the imaging device of Example 3, a gain measuring element 31 is arranged between the temperature detection element units arranged along the first direction. Here, the first infrared absorption layer 41 and the second infrared absorption layer 42 coat the first temperature detection element 21 and the second temperature detection element 22 substantially without a gap, but do not coat the gain measuring element 31.

In the example illustrated in Fig. 9, the gain measuring element 31 is arranged between the temperature detection element unit 20A or 20B including two temperature detection elements 21 and 22 and the temperature detection element unit 20A or 20B including two temperature detection elements 21 and 22. Then, in the temperature detection element unit, it is only required to perform correction of signal values obtained by the temperature detection elements 21 and 22, on the basis of an average value of signal values obtained by a gain measuring element 31L positioned on the left of the temperature detection element 21 in the drawing, and a gain measuring element 31R positioned on the right of the temperature detection element 22 in the drawing.

Furthermore, in the example illustrated in Fig. 10, the gain measuring element 31 is arranged between the temperature detection element unit 20A or 20B including four temperature detection elements 21 and 22 and the temperature detection element unit 20A or 20B including four temperature detection elements 21 and 22. Then, in the temperature detection element unit, it is only required to perform correction of signal values obtained by the four temperature detection elements 21 and 22, on the basis of an average value of signal values obtained by a gain measuring element (not illustrated, but indicated by reference numeral 31L) positioned on the left of the temperature detection element 21 positioned on the leftmost end of the drawing, and the gain measuring element 31R positioned on the right of the temperature detection element 22 positioned on the rightmost end.

The gain measuring element 31 has a configuration and a structure similar to those of the first temperature detection element 21 and the second temperature detection element 22 except that the infrared absorption layer is not provided (Example 3), or except that the infrared absorption layer is not thermally connected (Example 4). The same applies to the following description. The imaging devices of Examples 3 to 4 can be made to have the configuration and structure similar to those of the imaging devices described in Examples 1 to 2 except that the gain measuring element 31 is provided, and thus detailed description thereof will be omitted. Correction of a signal value obtained by the temperature detection element based on a signal value obtained by the gain measuring element in the following examples is only required to be performed substantially similar to the correction described above.

As described above, in the imaging device of Example 3 or later-described Example 4, since each temperature detection element unit includes the temperature detection element and the gain measuring element adjacent to each other along the first direction, correction can be performed of the signal value obtained by the temperature detection element on the basis of the signal value obtained by the gain measuring element, and as a result, variations can be suppressed in read signals in the temperature detection elements, and the temperature detection element can be miniaturized.

[Example 4]

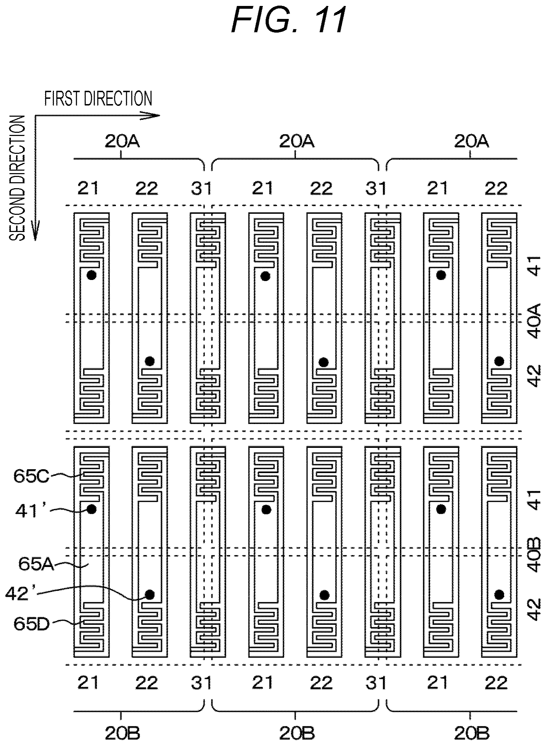

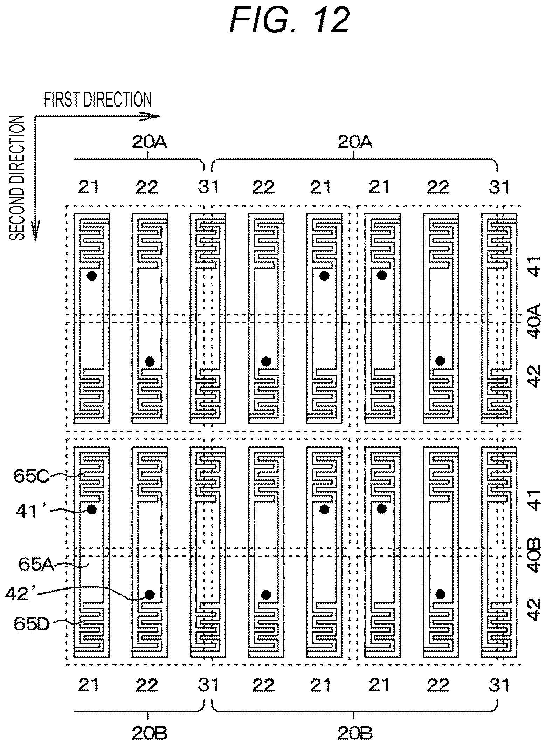

Example 4 is a modification of Example 3. An arrangement state of the temperature detection elements in the imaging device of Example 4 is schematically illustrated in Figs. 11 and 12.

In the imaging device of Example 4, the first infrared absorption layer 41 and the second infrared absorption layer 42 coat the first temperature detection element 21, the second temperature detection element 22, and the gain measuring element 31 substantially without a gap. Specifically, a gap is formed for separating the first infrared absorption layer 41 and the second infrared absorption layer 42 from each other, but a planar shape of a portion of the first infrared absorption layer 41 facing the second infrared absorption layer 42 and a planar shape of a portion of the second infrared absorption layer 42 facing the first infrared absorption layer 41 have complementary shapes.

In the example illustrated in Fig. 11, the gain measuring element 31 is arranged between the temperature detection element unit 20A or 20B including two temperature detection elements 21 and 22 and the temperature detection element unit 20A or 20B including two temperature detection elements 21 and 22. Specifically, the infrared absorption layers 41 and 42 are arranged above the temperature detection elements 21 and 22 and coat the temperature detection elements 21 and 22, and moreover, arranged above a part (for example, about 1/2) of the gain measuring element 31 and coat the part (for example, about 1/2) of the gain measuring element 31.

In the example illustrated in Fig. 12, the gain measuring element 31 is arranged between the temperature detection element unit 20A or 20B including four temperature detection elements 21 and 22 and the temperature detection element unit 20A or 20B including four temperature detection elements 21 and 22. Specifically, the infrared absorption layers 41 and 42 are arranged above the temperature detection elements 21 and 22 and coat these temperature detection elements 21 and 22, and moreover, arranged above a part (for example, about 1/2) of the gain measuring element 31 and coat the part (for example, about 1/2) of the gain measuring element 31.

Except for the points described above, the imaging device of Example 4 can be made to have the configuration and structure similar to those of the imaging device described in Example 3, and thus detailed description thereof will be omitted.

[Example 5]

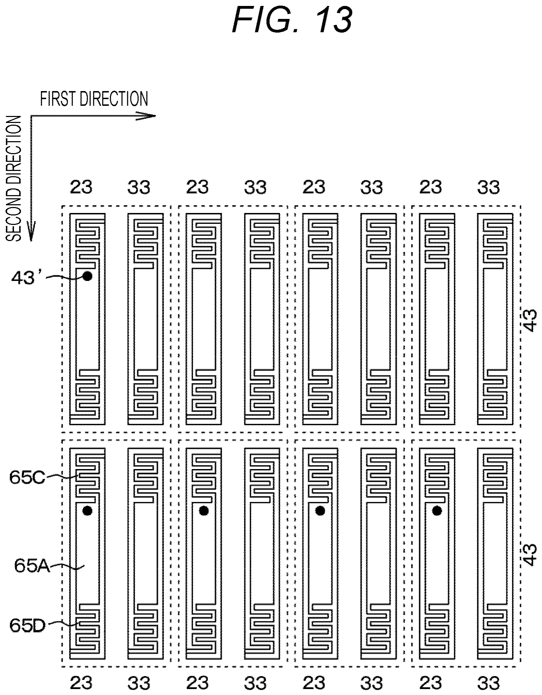

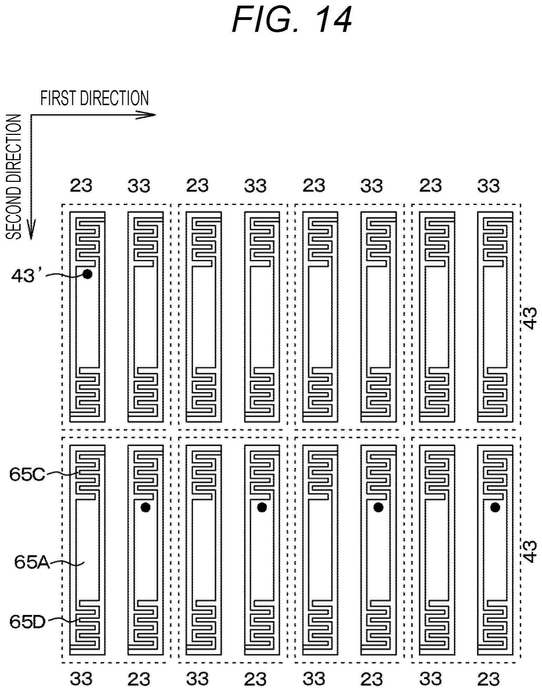

Example 5 relates to the imaging device according to the second aspect of the present disclosure. An arrangement state of temperature detection elements in an imaging device of Example 5 is schematically illustrated in Figs. 13 and 14.

The imaging device of Example 5 and an imaging device of Modification-1 thereof illustrated in Figs. 13 and 14 each include

a plurality of temperature detection element units arranged along a first direction and a second direction different from the first direction, in which
each of the temperature detection element units includes a temperature detection element 23 and a gain measuring element 33 adjacent to each other along any one of the first direction and the second direction (specifically, along the first direction in the illustrated example)
an infrared absorption layer 43 is arranged apart from the temperature detection element 23 and the gain measuring element 33 along an infrared incident direction, and
the infrared absorption layer 43 is thermally connected to the temperature detection element 23 and is not thermally connected to the gain measuring element 33.

The infrared absorption layer 43 is thermally connected to the temperature detection element 23 at a connection portion 43'. In the example illustrated in Fig. 13, a temperature detection element 23 and another temperature detection element 23 are adjacent to each other along the second direction, and a gain measuring element 33 and another gain measuring element 33 are adjacent to each other along the second direction. On the other hand, in the example illustrated in Fig. 14, a temperature detection element 23 and a gain measuring element 33 are adjacent to each other along the second direction, and another gain measuring element 33 and another temperature detection element 23 are adjacent to each other along the second direction.

In the imaging device of Example 5, each of the temperature detection element units includes a temperature detection element and a gain measuring element adjacent to each other along any one of the first direction and the second direction, an infrared absorption layer is arranged apart from the temperature detection element and the gain measuring element, and the infrared absorption layer is thermally connected to the temperature detection element and is not thermally connected to the gain measuring element, so that correction can be performed of the signal value obtained by the temperature detection element on the basis of the signal value obtained by the gain measuring element, and as a result, variations can be suppressed in read signals in the temperature detection elements, and the temperature detection element can be miniaturized.

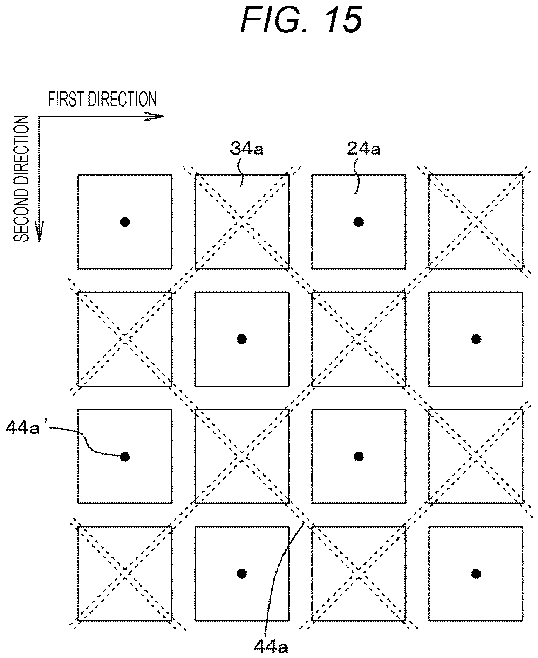

In an imaging device of a modification (Modification-2) of Example 5 illustrated in Fig. 15, planar shapes of a temperature detection element 24a and an infrared absorption layer 44a are different from planar shapes of the temperature detection element 23 and the infrared absorption layer 43 in the imaging device of Example 5 illustrated in Figs. 13 and 14. The infrared absorption layer 44a is thermally connected to the temperature detection element 24a at a connection portion 44a', but is not thermally connected to a gain measuring element 34a.

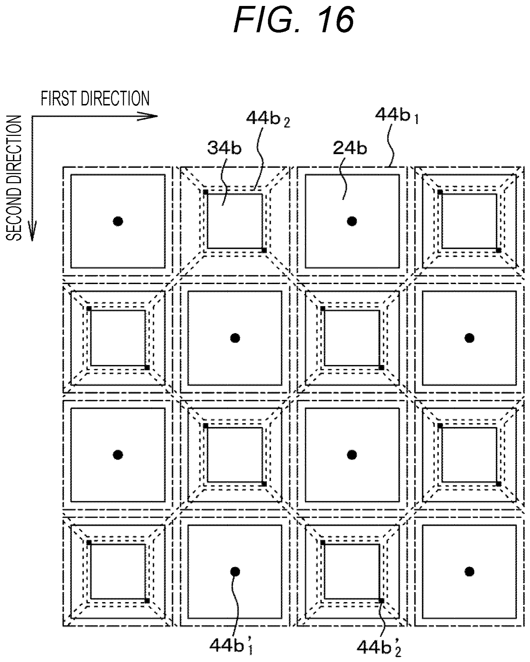

In an imaging device of a modification (Modification-3) of Example 5 illustrated in Fig. 16

the infrared absorption layer includes a first infrared absorption layer $44b_1$ and a second infrared absorption layer $44b_2$,

an orthographic image of the first infrared absorption layer $44b_1$ overlaps a temperature detection element 24b, and moreover, overlaps a part of a gain measuring element 34b,

an orthographic image of the second infrared absorption layer $44b_2$ overlaps a part of the gain measuring element 34b, and does not overlap the temperature detection element 24b,

the first infrared absorption layer $44b_1$ is thermally connected to the temperature detection element 24b at a connection portion $44b_1$', and is not thermally connected to the gain measuring element 34b, and

the second infrared absorption layer $44b_2$ is not thermally connected to the temperature detection element 24b and is not thermally connected to the gain measuring element 34b. The second infrared absorption layer $44b_2$ is supported on the partition wall 63 by support portions $44b_2$' provided at two locations. A planar shape of the first infrared absorption layer $44b_1$ is larger than a planar shape of the second infrared absorption layer $44b_2$.

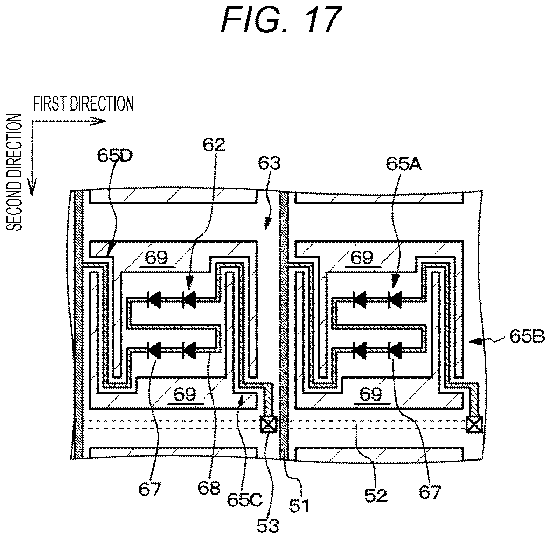

Configurations and structures of the temperature detection elements 23 and 24 will be described in detail in Example 10, as those of the temperature detection element 15; however, a configuration of the temperature detection element in the modifications (Modification-2, Modification-3) of the imaging device of the Example 5 is schematically illustrated in Fig. 17.

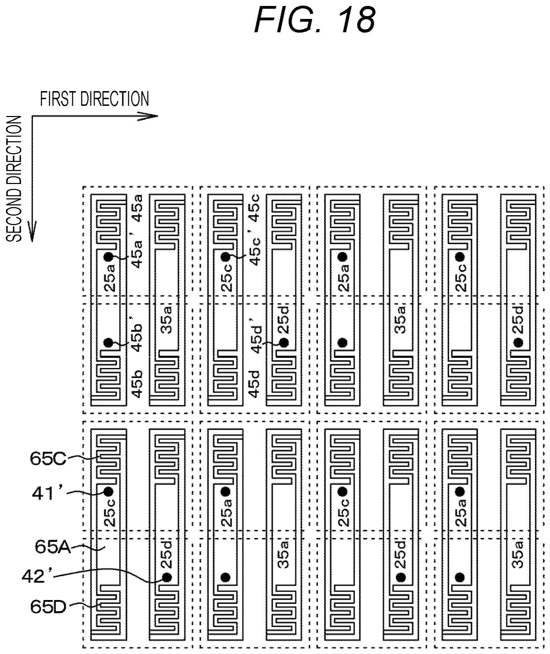

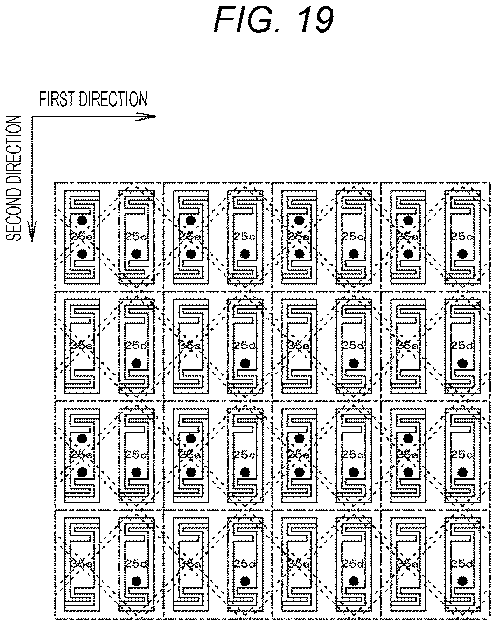

In imaging devices of modifications (Modification-4, Modification-5) of Example 5 illustrated in Figs. 18 and 19,

the infrared absorption layer includes a first infrared absorption layer 45a and a second infrared absorption layer 45b, an orthographic image of the first infrared absorption layer 45a overlaps a temperature detection element 25a and a gain measuring element 35a,

an orthographic image of the second infrared absorption layer 45b overlaps the temperature detection element 25a and the gain measuring element 35a,

the first infrared absorption layer 45a is thermally connected to the temperature detection element 25a at a connection portion 45a' and is not thermally connected to the gain measuring element 35a, and

the second infrared absorption layer 45b is thermally connected to the temperature detection element 25a at a connection portion 45b', and is not thermally connected to the gain measuring element 35a. Then,

the temperature detection element 25a and the gain measuring element 35a are adjacent to each other along the second direction,

the temperature detection element unit further includes a temperature detection element-A (25c) and a temperature detection element-B (25d),

the temperature detection element 25a and the temperature detection element-A (25c) are arranged along the first direction,

the gain measuring element 35a and the temperature detection element-B (25d) are arranged along the first direction,

an infrared absorption layer-A (45c) and an infrared absorption layer-B (45d) are arranged apart from the temperature detection element-A (25c) and the temperature detection element-B (25d) along an infrared incident direction,

the infrared absorption layer-A (45c) is arranged apart from the infrared absorption layer-B (45d) along the second direction,

the infrared absorption layer-A (45c) is thermally connected to the temperature detection element-A (25c) at a connection portion 45c', and

the infrared absorption layer-B is thermally connected to the temperature detection element-B (25d) at a connection portion 45d'.

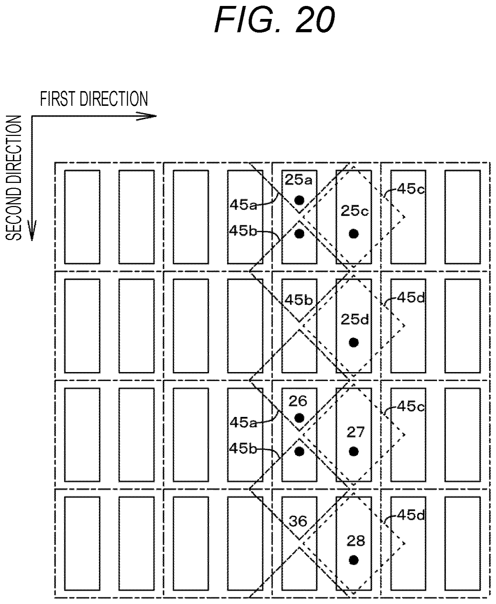

Note that, in the modification (Modification-5) of the imaging device of Example 5, arrangements of temperature detection element units and infrared absorption layer units are schematically illustrated in Fig. 20.

As described above, the second infrared absorption layer 45b is thermally connected to the temperature detection element 25a at the connection portion 45b' and is not thermally connected to the gain measuring element 35a, so that the temperature detection element 25a has, for example, twice the sensitivity to infrared rays of the other temperature detection elements [temperature detection element-A (25c), temperature detection element-B (25d)].

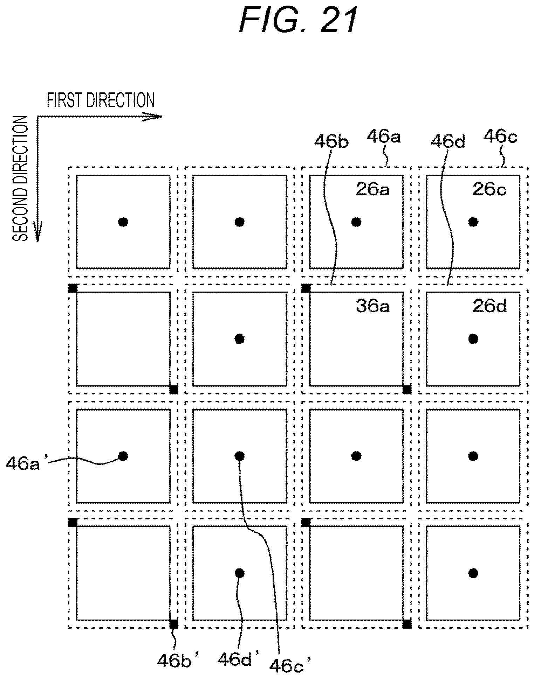

In an imaging device of a modification (Modification-6) of Example 5 illustrated in Fig. 21,

the infrared absorption layer includes a first infrared absorption layer 46a and a second infrared absorption layer 46b, an orthographic image of the first infrared absorption layer 46a overlaps a temperature detection element 26a and a gain measuring element 36a,
an orthographic image of the second infrared absorption layer 46b overlaps the temperature detection element 26a and the gain measuring element 36a,
the first infrared absorption layer 46a is thermally connected to the temperature detection element 26a, and is not thermally connected to the gain measuring element 36a, and
the second infrared absorption layer 46b is not thermally connected to the temperature detection element 26a and is not thermally connected to the gain measuring element 36a. The second infrared absorption layer 46b is supported on the partition wall 63 by support portions 46b' provided at two locations. Then, in this case,
the temperature detection element 26a and the gain measuring element 36a are adjacent to each other along the second direction,
the temperature detection element unit further includes a temperature detection element-A (26c) and a temperature detection element-B (26d),
the temperature detection element 26a and the temperature detection element-A (26c) are arranged along the first direction,
the gain measuring element 31 and the temperature detection element-B (26d) are arranged along the first direction,
an infrared absorption layer-A (46c) and an infrared absorption layer-B (46d) are arranged apart from the temperature detection element-A (26c) and the temperature detection element-B (26d) along an infrared incident direction,
the infrared absorption layer-A (46c) is arranged apart from the infrared absorption layer-B (46d) along the second direction,
the infrared absorption layer-A (46c) is thermally connected to the temperature detection element-A (26c) at a connection portion 46c', and
the infrared absorption layer-B (46d) is thermally connected to the temperature detection element-B (26d) at a connection portion 46d'.

Except for the points described above, the imaging device of Example 5 can be made to have the configuration and structure similar to those of the imaging device described in Example 4, and thus detailed description thereof will be omitted.

[Example 6]

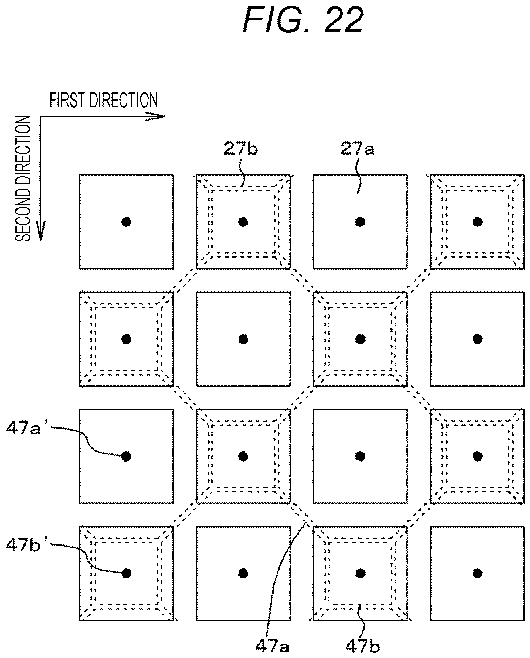

Example 6 relates to the imaging device according to the third aspect of the present disclosure. An arrangement state of temperature detection elements in an imaging device of Example 6 is schematically illustrated in Fig. 22.
The imaging device of Example 6 includes:

a plurality of temperature detection element units arranged each including two or more (specifically, two in Example 6) temperature detection elements 27a and 27b; and
infrared absorption layers 47a and 47b arranged apart from the respective temperature detection elements 27a and 27b along an infrared incident direction and thermally connected to the temperature detection elements 27a and 27b, in which
in the temperature detection element units, sizes of orthographic images of the infrared absorption layers 47a and 47b are different for each of the temperature detection elements. In the illustrated example, the size of the orthographic image of the infrared absorption layer 47a is larger than the size of the orthographic image of the infrared absorption layer 47b.

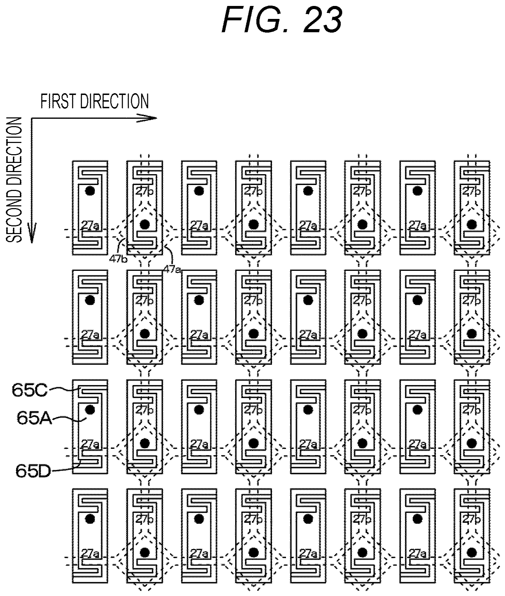

Except for the points described above, the configurations and structures of the temperature detection element and the infrared absorption layer in the imaging device of Example 6 can be made to be substantially similar to the configurations and structures of the temperature detection element and the infrared absorption layer in the imaging device described in Modification-2 or Modification-3 of Example 5, and thus detailed description thereof will be omitted.
In the imaging device of Example 6, since the size of the orthographic image of the infrared absorption layer in the temperature detection element unit is different for each temperature detection element, variations can be suppressed in read signals in the temperature detection elements, and the temperature detection element can be miniaturized.
An arrangement state of the temperature detection elements in a modification of the imaging device of Example 6 is schematically illustrated in Fig. 23, and the planar shape of the infrared absorption layer may be different from that illustrated in Fig. 22.

[Example 7]

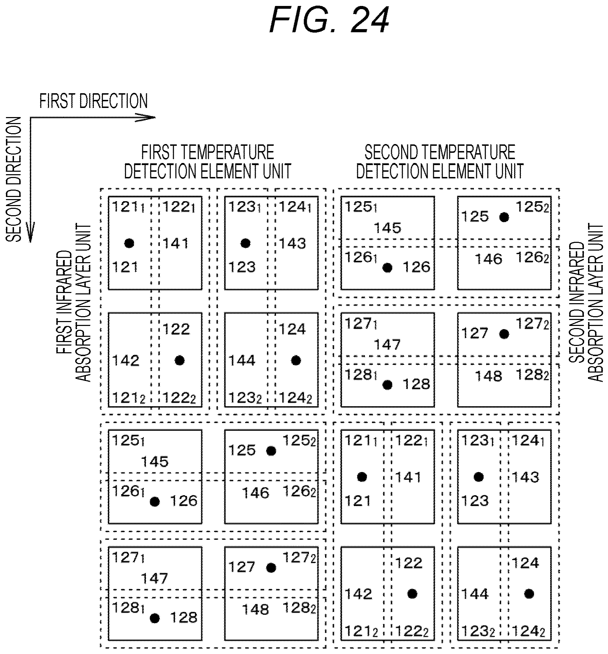

Example 7 relates to the imaging device according to the fourth aspect of the present disclosure. An arrangement state of temperature detection elements in an imaging device of Example 7 is schematically illustrated in Fig. 24.
The imaging device of Example 7 includes:

a plurality of temperature detection element units arranged along a first direction and a second direction different from the first direction; and
a plurality of infrared absorption layer units arranged along the first direction and the second direction, in which
each of the temperature detection element units includes a first temperature detection element unit and a second temperature detection element unit arranged together with the first temperature detection element unit along the first direction,
each of the first temperature detection element unit and the second temperature detection element unit includes a plurality of temperature detection elements (121, 122, 123, 124, and 125, 126, 127, 128) arranged along the first direction and the second direction,
each of the infrared absorption layer units includes a first infrared absorption layer unit arranged apart from the first temperature detection element unit along an infrared incident direction, and a second infrared absorption layer unit arranged apart from the second temperature detection element unit along the infrared incident direction,
the first infrared absorption layer unit includes a plurality of infrared absorption layers (141, 142, 143, 144) extending along the second direction and arranged side by side along the first direction,
one of the temperature detection elements constituting the first temperature detection element unit is thermally connected to one of the infrared absorption layers constituting the first infrared absorption layer unit,
the second infrared absorption layer unit includes a plurality of infrared absorption layers (145, 146, 147, 148) extending along the first direction and arranged side by side along the second direction, and
one of the temperature detection elements constituting the second temperature detection element unit is thermally connected to one of the infrared absorption layers constituting the second infrared absorption layer unit.

Then, the first temperature detection element unit and the second temperature detection element unit are arranged in a checkerboard pattern along the first direction and the second direction.
Here, specifically,

the first temperature detection element unit includes the first temperature detection element 121 and the second temperature detection element 122 arranged along the first direction, and, along the second direction, the third temperature detection element 123 arranged adjacent to the first temperature detection element 121, and, the fourth temperature detection element 124 arranged adjacent to the second temperature detection element 122, and
the second temperature detection element unit includes the fifth temperature detection element 125 and the sixth temperature detection element 126 arranged along the first direction, and, along the second direction, the seventh temperature detection element 127 arranged adjacent to the fifth temperature detection element 125, and the eighth temperature detection element 128 arranged adjacent to the sixth temperature detection element 126.

Then,

the first temperature detection element 121 includes a first A region $121_1$ and a first B region $121_2$ in contact with the first A region $121_1$ along the second direction,
the second temperature detection element 122 includes a second A region $122_1$ and a second B region $122_2$ in contact with the second A region $122_1$ along the second direction,
the third temperature detection element 123 includes a third A region $123_1$ and a third B region $123_2$ in contact with the third A region $123_1$ along the second direction,
the fourth temperature detection element 124 includes a fourth A region $124_1$ and a fourth B region $124_2$ in contact with the fourth A region $124_1$ along the second direction,
the fifth temperature detection element 125 includes a fifth A region $125_1$, and a fifth B region $125_2$ in contact with the fifth A region $125_1$ along the first direction,
the sixth temperature detection element 126 includes a sixth A region $126_1$ and a sixth B region $126_2$ in contact with the sixth A region $126_1$ along the first direction,
the seventh temperature detection element 127 includes a seventh A region $127_1$, and a seventh B region $127_2$ in contact with the seventh A region $127_1$ along the first direction,

the eighth temperature detection element 128 includes an eighth A region $128_1$, and an eighth B region $128_2$ in contact with the eighth A region $128_1$ along the first direction,

the first infrared absorption layer unit includes the first infrared absorption layer 141, the second infrared absorption layer 142, the third infrared absorption layer 143, and the fourth infrared absorption layer 144,

the second infrared absorption layer unit includes the fifth infrared absorption layer 145, the sixth infrared absorption layer 146, the seventh infrared absorption layer 147, and the eighth infrared absorption layer 148,

the first infrared absorption layer 141 is arranged apart from the first A region $121_1$ and the second A region $122_1$ along the infrared incident direction, and is thermally connected to the first temperature detection element 121,

the second infrared absorption layer 142 is arranged apart from the first B region $121_2$ and the second B region $122_2$ along the infrared incident direction, and is thermally connected to the second temperature detection element 122,

the third infrared absorption layer 143 is arranged apart from the third A region $123_1$ and the fourth A region $124_1$ along the infrared incident direction, and is thermally connected to the third temperature detection element 123,

the fourth infrared absorption layer 144 is arranged apart from the third B region $123_2$ and the fourth B region $124_2$ along the infrared incident direction, and is thermally connected to the fourth temperature detection element 124,

the fifth infrared absorption layer is arranged apart from the fifth A region $125_1$ and the sixth A region $126_1$ along the infrared incident direction, and is thermally connected to the fifth temperature detection element 125,

the sixth infrared absorption layer is arranged apart from the fifth B region $125_2$ and the sixth B region $126_2$ along the infrared incident direction, and is thermally connected to the sixth temperature detection element 126,

the seventh infrared absorption layer is arranged apart from the seventh A region $127_1$ and the eighth A region $128_1$ along the infrared incident direction, and is thermally connected to the seventh temperature detection element 127, and

the eighth infrared absorption layer is arranged apart from the seventh B region $127_2$ and the eighth B region $128_2$ along the infrared incident direction, and is thermally connected to the eighth temperature detection element 128.

Except for the points described above, the configurations and structures of the temperature detection element and the infrared absorption layer in the imaging device of Example 7 can be made to be substantially similar to the configurations and structures of the temperature detection element and the infrared absorption layer in the imaging device described in Example 1, or the configurations and structures of the temperature detection element and the infrared absorption layer in the imaging device described in Modification 2 or Modification 3 of Example 5, and thus detailed description thereof will be omitted.

In the imaging device of Example 7, the first infrared absorption layer unit includes a plurality of infrared absorption layers extending along the second direction and arranged side by side along the first direction, and the second infrared absorption layer unit includes a plurality of infrared absorption layers extending along the first direction and arranged side by side along the second direction, so that a function similar to a Wire Grid Polarizer (WGP) is performed due to a combination of the first temperature detection element unit and the infrared absorption layer unit, and as a result, a difference occurs in signals obtained by the first temperature detection element unit and the second temperature detection element unit depending on a polarization state of infrared rays, and the polarization state of the infrared rays can be obtained.

[Example 8]

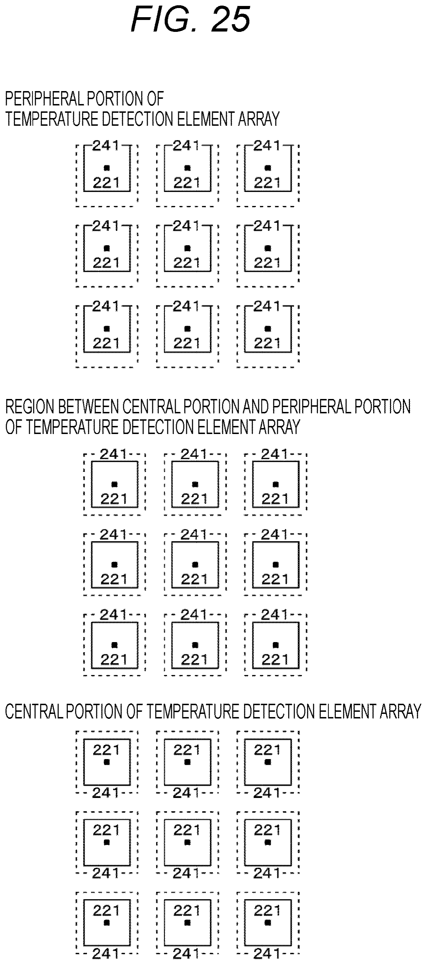

Example 8 relates to the imaging device according to the fifth aspect of the present disclosure. An arrangement state of temperature detection elements in an imaging device of Example 8 is schematically illustrated in Fig. 25.

The imaging device of Example 8 includes

a temperature detection element array including a plurality of temperature detection elements 221 arranged along a first direction and a second direction different from the first direction, and

infrared absorption layers 241 arranged apart from the respective temperature detection elements 221 along an infrared incident direction and thermally connected to the temperature detection elements 221, in which

a distance from an orthographic image of the center of each of the temperature detection elements 221 to an orthographic image of the center of each of the infrared absorption layers 241 is longer in the temperature detection element 221 positioned in a peripheral portion of the temperature detection element array than in the temperature detection element 221 positioned in a central portion of the temperature detection element array.

That is, when a distance from the orthographic image of the center of the temperature detection element 221 in the temperature detection element 221 positioned in the central portion of the temperature detection element array to the orthographic image of the center of the infrared absorption layer 241 is $D_C$, and a distance from the orthographic image of the center of the temperature detection element 221 in the temperature detection element 221 positioned in the peripheral portion of the temperature detection element array to the orthographic image of the center of the infrared absorption layer 241 is $D_S$, there is a relationship of $D_S > D_C$. The infrared absorption layer 241 is shifted from the temperature detection element 221 toward the central portion of the temperature detection element array. In Fig. 25, the orthographic image of the center of the temperature detection element 221 is illustrated by a black square. Furthermore, the temperature detection element 221 is illustrated by a solid line square, and the infrared absorption layer 241 is illustrated by a broken line square.

A mode can be made in which a concentric region (annular region) is set from the central portion of the temperature detection element array, and distances from the orthographic image of the center of the temperature detection element 221 in the temperature detection element 221 to the orthographic image of the center of the infrared absorption layer 241 are the same as each other in one region, and the distance from the orthographic image of the center of the temperature detection element 221 in the temperature detection element 221 to the orthographic image of the center of the infrared absorption layer 241 is increased as a region is positioned on the peripheral portion side of the temperature detection element array. In Fig. 25, the diagram illustrated in the upper stage illustrates $3 \times 3$ temperature detection elements 221 and infrared absorption layers 241 in the peripheral portion of the temperature detection element array, the diagram illustrated in the middle stage illustrates $3 \times 3$ temperature detection elements 221 and infrared absorption layers 241 in a region between the central portion and the peripheral portion of the temperature detection element array, and the diagram illustrated in the lower stage illustrates $3 \times 3$ temperature detection elements 221 and infrared absorption layers 241 in the central portion of the temperature detection element array. Furthermore, the orthographic image of the center of the infrared absorption layer 241 is preferably positioned on a straight line, or generally on the straight line connecting the orthographic image of the center of the temperature detection element 221 in the temperature detection element 221 positioned in the central portion of the temperature detection element array to the orthographic image of the center of the temperature detection element 221 in the temperature detection element 221 positioned in the peripheral portion of the temperature detection element array.

Except for the points described above, the configurations and structures of the temperature detection element and the infrared absorption layer in the imaging device of Example 8 can be made to be substantially similar to the configurations and structures of the temperature detection element and the infrared absorption layer in the imaging device described in Example 1, or the configurations and structures of the temperature detection element and the infrared absorption layer in the imaging device described in Modification 2 or Modification 3 of Example 5, and thus detailed description thereof will be omitted.

In the imaging device of Example 8, the distance from the orthographic image of the center of the temperature detection element to the orthographic image of the center of the infrared absorption layer is longer in the temperature detection element positioned in the peripheral portion of the temperature detection element array than in the temperature detection element positioned in the central portion of the temperature detection element array, or in an imaging device of Example 9 described later, the size of the infrared absorption layer is larger in the temperature detection element positioned in the peripheral portion of the temperature detection element array than in the temperature detection element positioned in the central portion of the temperature detection element array. Thus, it is possible to provide an imaging device in which variations are small in temperature detection depending on the arrangement position of the temperature detection elements.

[Example 9]

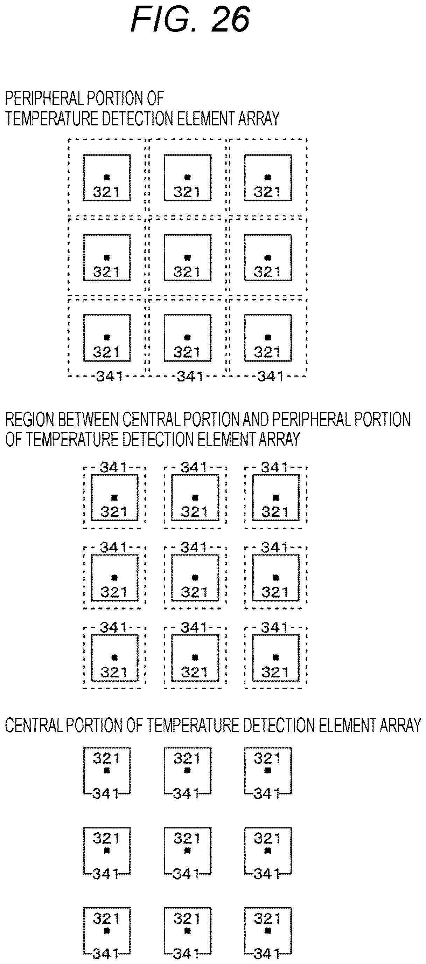

Example 9 relates to the imaging device according to the sixth aspect of the present disclosure. An arrangement state of temperature detection elements in an imaging device of Example 9 is schematically illustrated in Fig. 26.

The imaging device of Example 9 includes

a temperature detection element array including a plurality of temperature detection elements 321 arranged along a first direction and a second direction different from the first direction, and
infrared absorption layers 341 arranged apart from the respective temperature detection elements 321 along an infrared incident direction and thermally connected to the temperature detection elements 321, in which
a size of each of the infrared absorption layers 341 is larger in the temperature detection elements 321 positioned in a peripheral portion of the temperature detection element array than in the temperature detection elements 321 positioned in a central portion of the temperature detection element array.

A mode can be made in which a concentric region (annular region) is set from the central portion of the temperature detection element array, and sizes of the infrared absorption layers 341 are the same as each other in one region, and the size of the infrared absorption layer 341 is increased as a region is positioned on the peripheral portion side of the temperature detection element array. In Fig. 26, the orthographic image of the center of the temperature detection element 321 is illustrated by a black square. Furthermore, the temperature detection element 321 is illustrated by a solid line square, and the infrared absorption layer 341 is illustrated by a broken line square. Moreover, in Fig. 26, the diagram illustrated in the upper stage illustrates 3 × 3 temperature detection elements 321 and infrared absorption layers 341 in the peripheral portion of the temperature detection element array, the diagram illustrated in the middle stage illustrates 3 × 3 temperature detection elements 321 and infrared absorption layers 341 in a region between the central portion and the peripheral portion of the temperature detection element array, and the diagram illustrated in the lower stage illustrates 3 × 3 temperature detection elements 321 and infrared absorption layers 341 in the central portion of the temperature detection element array.

Except for the points described above, the configurations and structures of the temperature detection element and the infrared absorption layer in the imaging device of Example 9 can be made to be substantially similar to the configurations and structures of the temperature detection element and the infrared absorption layer in the imaging device described in Example 1, or the configurations and structures of the temperature detection element and the infrared absorption layer in the imaging device described in Modification 2 or Modification 3 of Example 5, and thus detailed description thereof will be omitted. Furthermore, Examples 8 and 9 can be combined.

[Example 10]

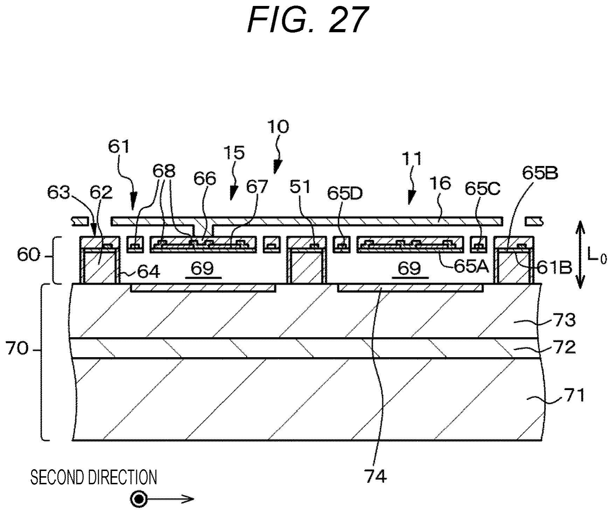

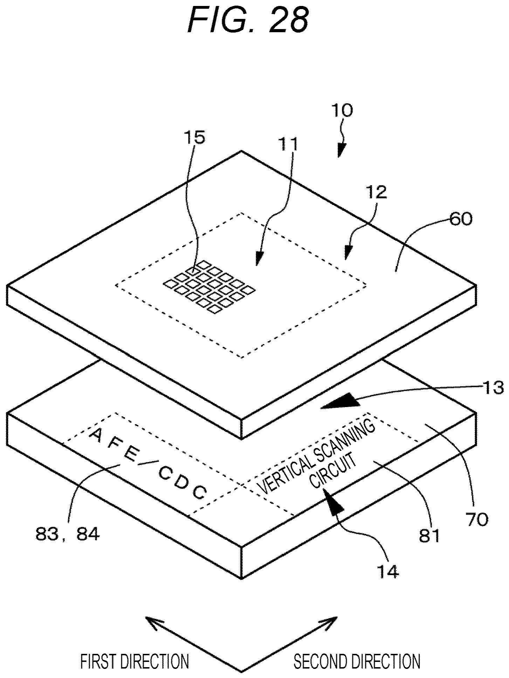

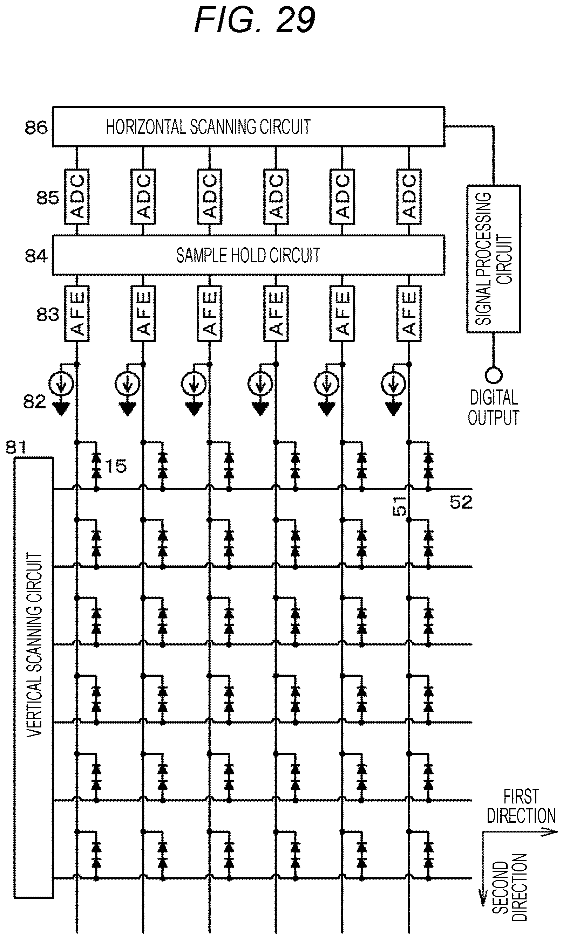

In Example 10, the temperature detection element and the infrared absorption layer will be described. A schematic partial end view of the temperature detection element and the infrared absorption layer in Example 10 is illustrated in Fig. 27. Fig. 27 is a schematic partial end view along the first direction, but only the pn junction diode 67 and the wiring line 68 are illustrated as a schematic partial end view along the second direction. Furthermore, a schematic exploded perspective view of a first structural body and a second structural body in the imaging device of Examples 1 to 9 is illustrated in Fig. 28, and an equivalent circuit diagram of the imaging device of Examples 1 to 9 is illustrated in Fig. 29. The imaging device described in Example 10 is specifically a face-to-back structure imaging device, as described later.

In the following, first, an outline will be described of the imaging device of Example 10, and then details will be described of the imaging device of Example 10.

In the imaging device of Example 10, a configuration can be made in which: a partition wall is formed in a portion of the first substrate positioned between the temperature detection elements; and the bottom of the partition wall is bonded to the coating layer. Note that, the imaging device having such a configuration is referred to as a "face-to-back structure imaging device" for convenience. In a case where a surface of the first substrate facing the second substrate is referred to as a "first substrate's first surface", and a surface of the first substrate facing the first surface of the first substrate is referred to as a "first substrate's second surface", the temperature detection element is provided on the first substrate's second surface side. Bonding between the coating layer provided on the second substrate and the first substrate, specifically, bonding between the bottom of the partition wall and the coating layer can be performed on the basis of, for example, a method such as formation of a silicon-oxygen covalent bond by dehydration condensation.

Then, in the face-to-back structure imaging device, a configuration can be made in which: an exposed surface of the coating layer exposed in the void includes at least one type of material layer selected from the group consisting of an insulating material layer, a metal material layer, an alloy material layer, and a carbon material layer; a side wall of the partition wall includes at least one type of material layer selected from the group consisting of an insulating material layer, a metal material layer, an alloy material layer, and a carbon material layer. The inside of the partition wall surrounded by the side wall of the partition wall includes a part of the first substrate. In some cases, the inside of the partition wall may include the same material as a material forming the side wall of the partition wall, or may include a material different from a material forming the first substrate or the side wall of the partition wall.

Alternatively, in the face-to-back structure imaging device, a configuration can be made in which the exposed surface of the coating layer exposed in the void includes at least one type of material layer selected from the group consisting of an insulating material layer, a metal material layer, an alloy material layer, and a carbon material layer. Then, in the face-to-back structure imaging device including such a configuration, a configuration can be made in which the side wall of the partition wall includes at least one type of material layer selected from the group consisting of an insulating material layer, a metal material layer, an alloy material layer, and a carbon material layer.

As the insulating material layer forming the exposed surface of the coating layer exposed in the void, an insulating material layer including an oxide (specifically, for example, $SiO_X$ ($1 \leq X \leq 2$), SiOF, SiOC), an insulating material layer including nitride (specifically, for example, SiN), an insulating material layer including an oxynitride (specifically, for example, SiON), and an adhesive material layer can be mentioned; as the metal material layer forming the exposed surface of the coating layer exposed in the void, gold (Au), copper (Cu), aluminum (Al), tungsten (W), and titanium (Ti) can be mentioned; as the alloy material layer forming the exposed surface of the coating layer exposed in the void, an alloy layer and a solder layer containing these metals can be mentioned; and as the carbon material layer forming the exposed surface of the coating layer exposed in the void, a carbon film and a carbon nanotube can be mentioned.

Furthermore, as the insulating material layer, the metal material layer, the alloy material layer, and the carbon material layer forming the side wall of the partition wall, the various materials described above can be mentioned.

As combinations of (material of the insulating material layer forming the exposed surface of the coating layer exposed in the void, material of the insulating material layer forming the side wall of the partition wall), 16 combinations can be mentioned of (insulating material layer, insulating material layer), (insulating material layer, metal material layer), (insulating material layer, alloy material layer), (insulating material layer, carbon material layer), (metal material layer, insulating material layer), (metal material layer, metal material layer), (metal material layer, alloy material layer), (metal material layer, carbon material layer), (alloy material layer, insulating material layer), (alloy material layer, metal material layer), (alloy material layer, alloy material layer), (alloy material layer, carbon material layer), (carbon material layer, insulating material layer), (carbon material layer, metal material layer), (carbon material layer, alloy material layer), and (carbon material layer, carbon material layer).

The insulating material layer forming the exposed surface of the coating layer exposed in the void and the insulating material layer forming the side wall of the partition wall may include the same material or may include different materials. The metal material layer forming the exposed surface of the coating layer exposed in the void and the metal material layer forming the side wall of the partition wall may include the same material or may include different materials. The alloy material layer forming the exposed surface of the coating layer exposed in the void and the alloy material layer forming the side wall of the partition wall may include the same material or may include different materials. The carbon material layer forming the exposed surface of the coating layer exposed in the void and the carbon material layer forming the side wall of the partition wall may include the same material or may include different materials.

Moreover, a mode can be made in which a heat conductive layer is formed in the coating layer. The heat conductive layer may have high heat conductivity or, conversely, may have low heat conductivity. As materials forming the heat conductive layer having high heat conductivity, metal materials, carbon-based materials such as a carbon film and a carbon nanotube can be mentioned, and as materials forming the heat conducting layer having low heat conductivity, organic materials can be mentioned. The heat conductive layer is preferably formed on the entire surface of the temperature detection element array region, but this is not a limitation. Furthermore, the heat conductive layer is preferably arranged inside the coating layer and below the infrared reflection layer, but this is not a limitation. In some cases, the heat conductive layer may also serve as the infrared reflection layer.

Moreover, a configuration can be made in which a temperature control layer is formed in the coating layer, and a temperature detection means is further included, whereby the temperature and temperature distribution of the temperature detection element can be controlled with high accuracy. Here, a configuration can be made in which the temperature control layer functions as a heater (resistor, resistance member), and for example, a configuration can be made in which the temperature control layer also serves as a wiring line. Specifically, as the temperature detection means, a silicon diode, a transistor, or a polysilicon thin film that detects a temperature by measuring a change in an electric resistance value depending on the temperature can be exemplified; as materials forming the temperature control layer also serving as a wiring line, a polysilicon film, a titanium film, and a metal-based material film such as a tungsten film can be mentioned; and as materials forming the temperature control layer, a laminated film using the Peltier effect, and a carbon film can be mentioned. In some cases, the temperature control layer may be provided on the second substrate. Moreover, in these cases, a configuration can be made in which the drive circuit controls the temperature control layer on the basis of a temperature detection result of the temperature detection means (specifically, for example, a current flowing through the temperature control layer is controlled, and thus an amount of heat generation of the temperature control layer is controlled). Then, in these configurations,

a configuration can be made in which the first structural body includes a temperature detection element array region including the temperature detection element, and a peripheral region surrounding the temperature detection element array region, and

the temperature control layer is formed in the temperature detection element array region, or alternatively, a configuration can be made in which the temperature control layer is formed in a region of the coating layer where an orthographic image of the temperature detection element array region exists, or, alternatively, a configuration can be made in which the drive circuit includes an analog-digital conversion circuit (ADC), and the analog-digital conversion circuit is not arranged in a region of a drive substrate where an orthographic image of the temperature detection element array region exists. Since the analog-digital conversion circuit generates a large amount of heat, the temperature can be made more uniform by adopting such a configuration. Note that, arrangement of such a temperature control layer can also be applied to a structure in which a known light-receiving element (light-receiving element that receives visible light) is formed instead of the temperature detection element. Furthermore, in some cases, the temperature control layer may also serve as the infrared reflection layer.

An imaging device 10 of Example 10 specifically includes

a first structural body 60 and a second structural body 70, in which

the first structural body 60 includes:

> the first substrate 61;
> the temperature detection element 15 that is provided on the first substrate 61 and detects a temperature on the basis of infrared rays; and
> the drive line 52 and the signal line 51 connected to the temperature detection element 15,
> the second structural body 70 includes:
>
> > a second substrate 71; and
> > the drive circuit provided on the second substrate 71 and coated with a coating layer (interlayer insulating layer) 73,
> > the first substrate 61 is bonded to the coating layer 73,
> > the void 69 is provided between the temperature detection element 15 and the coating layer 73, and
> > the drive line 52 and the signal line 51 are electrically connected to the drive circuit.

Note that, in the drawings, a layer in which the drive circuit is formed is schematically illustrated with a reference numeral 72. Here, as illustrated in Fig. 28, the first structural body 60 includes a temperature detection element array region 11 (illustrated surrounded by a dotted line) including the temperature detection element 15, and a peripheral region 12 surrounding the temperature detection element array region 11, and in the peripheral region 12, the drive line 52 and the signal line 51 are electrically connected to the drive circuit. Note that, a central region of the second structural body 70 is indicated by a reference numeral 13, and a peripheral region of the second structural body 70 is indicated by a reference numeral 14.

The drive line 52 and the signal line 51 are electrically connected to the drive circuit in the peripheral regions 12 and 14 by, for example, a through silicon via (TSV), but illustration of the through silicon via (TSV) is omitted. In the peripheral region 14 of the second structural body 70, for example, a region in which an analog front end (AFE) 83 including a differential integration circuit constituting the drive circuit, a sample hold circuit 84, and an analog-digital conversion circuit (ADC) 85 are provided, a constant current circuit 82, and a vertical scanning circuit 81 are arranged. The differential integration circuit has a function as an amplifier (preamplifier). Furthermore, in the central region 13 of the second structural body 70, for example, a horizontal scanning circuit 86 constituting the drive circuit, a CPU (or DSP), a signal processing circuit, a storage device (for example, a memory or a non-volatile memory), and the like are arranged. Note that, illustration is omitted of the CPU (or DSP), the signal processing circuit, and the storage device. The drive circuit included in the second structural body 70 can include a known drive circuit.

As described above, in the imaging device of Example 10, the first substrate 61 is bonded to the coating layer 73 formed on the second substrate 71, and the void 69 is provided between the temperature detection element 15 and the coating layer 73, so that the void 69 can be provided in the temperature detection element 15 with high accuracy, and the temperature detection element 15 having high measurement accuracy can be obtained.

In the imaging device 10 of Example 10, the partition wall 63 is formed in a portion of the first substrate 61 positioned between the temperature detection elements 15, and the bottom of the partition wall 63 is bonded to the coating layer 73. Here, the bottom of the partition wall 63 and the coating layer 73 are bonded together on the basis of a method such as formation of a silicon-oxygen covalent bond by dehydration condensation. A side wall 64 of the partition wall 63 includes at least one type of material layer selected from the group consisting of an insulating material layer, a metal material layer, an alloy material layer, and a carbon material layer. Specifically, in Example 10, the side wall 64 of the partition wall 63 includes an insulating material layer such as a $SiO_2$ layer. Furthermore, the inside of the partition wall 63 surrounded by the side wall 64 of the partition wall 63 includes a part of the first substrate 61, specifically, a silicon layer 62. The exposed surface of the coating layer 73 exposed in the void 69 includes at least one type of material layer selected from the group consisting of an insulating material layer, a metal material layer, an alloy material layer, and a carbon material layer. Specifically, in Example 10, the exposed surface of the coating layer 73 exposed in the void 69 includes an insulating material layer such as a $SiO_2$ layer, and below the $SiO_2$ layer, an interlayer insulating layer (not specifically illustrated) is formed including SiN or the like forming the coating layer 73. Note that, if the side wall 64 of the partition wall 63 includes a material that reflects infrared rays, the incident infrared rays can be effectively reflected.

A whole or a part of the first substrate 61 includes an SOI substrate, and the second structural body 70 includes the second substrate 71 including a silicon semiconductor substrate. The wiring line 68, the signal line 51, the drive line 52, and the contact hole 53 include, for example, an aluminum alloy.

On the side of the temperature detection element 15 on which infrared rays are incident (the second surface 61B of the first substrate 61), an infrared absorption layer 16 including an aluminum thin film is formed, and in a region of the coating layer 73 positioned at the bottom of the void 69, an infrared reflection layer 74 including a copper thin film is formed. In the illustrated example, the infrared reflection layer 74 is formed on a part of a portion of the coating layer 73 positioned at the bottom of the void 69. Furthermore, the infrared absorption layer 16 is formed above the temperature detection element 15. Specifically, on the insulating film 66, the infrared absorption layer 16 is formed in a state where a part is in contact with the insulating film 66 and a part has a gap from the insulating film 66 (a space is provided). The infrared reflection layer 74 is formed on the top surface of the coating layer 73. Then, when the wavelength of infrared rays to be absorbed by the infrared absorption layer 16 is $\lambda_{IR}$, the optical distance $L_0$ between the infrared absorption layer 16 and the infrared reflection layer 74 satisfies

$$0.75 \times \lambda_{IR}/2 \leq L_0 \leq 1.25 \times \lambda_{IR}/2$$

or

$$0.75 \times \lambda_{IR}/4 \leq L_0 \leq 1.25 \times \lambda_{IR}/4.$$

In Example 10, specifically,

$$L_0 = \lambda_{IR}/4$$

is satisfied. A value of $\lambda_{IR}$ is 8 um to 14 um, and in Example 10, specifically, $\lambda_{IR}$ = 10 um, but this is not a limitation. The wing-shaped infrared absorption layer 16 extends above the adjacent temperature detection element 15.

In the operation of the imaging device, one drive line 52 is selected under the control of the vertical scanning circuit 81. On the other hand, a constant current is supplied from the constant current circuit 82 to all the signal lines 51. In the selected temperature detection element 15, the temperature changes depending on the incident infrared rays, and this temperature change causes a change in the electric resistance value of the temperature detection element 15 (specifically, the pn junction diode 67). As a result, a change occurs in a voltage appearing on each signal line 51. The voltage of each signal line 51 is input to one input unit of the differential integration circuit constituting the analog front end (AFE) 83. On the other hand, a reference voltage is input to the other input unit of the differential integration circuit. In the differential integration circuit, the output of the temperature detection element 15 is amplified. Then, after a lapse of a predetermined time, an integrated value of a voltage difference is sent from the differential integration circuit to the sample hold circuit 84, an analog value held in the sample hold circuit 84 is output to the analog-digital conversion circuit (ADC) 85, and the integrated value of the voltage difference is converted into a digital value in the analog-digital conversion circuit 85 to be sent to the horizontal scanning circuit 86. Then, by the operation of the horizontal scanning circuit 86, the value is sequentially output for each of the temperature detection elements to the signal processing circuit, and finally output as a digital output.

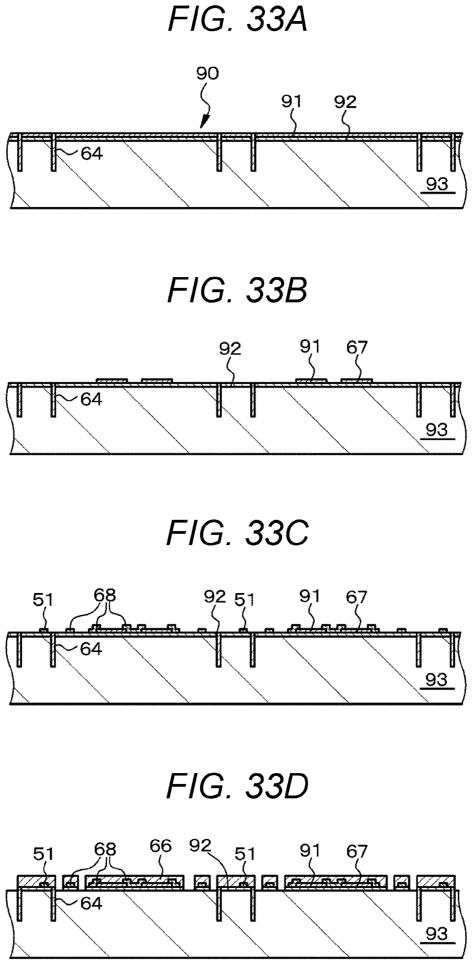

Hereinafter, an outline of a method of manufacturing the imaging device of Example 10, in particular, a method of manufacturing the first structural body 60 will be described with reference to Figs. 33A, 33B, 33C, 33D, 34A, 34B, 34C, 35A, 35B, 36A, and 36B that are schematic partial end views of the SOI substrate and the like. Note that, these drawings are schematic partial end views along the second direction.

[Step-100]

An SOI substrate 90 is prepared in which a first silicon layer 91 is formed on the surface and a SiO$_2$ layer 92 is formed under the first silicon layer 91. A portion of the silicon semiconductor substrate constituting the SOI substrate 90 positioned below the SiO$_2$ layer 92 is referred to as a "second silicon layer 93" for convenience. Then, first, a portion of the second silicon layer 93 of the SOI substrate 90 on which the side wall 64 of the partition wall 63 is to be formed is etched to form a groove portion, and the groove portion is filled with a material forming the side wall 64 (see Fig. 33A). Thereafter, the first silicon layer 91 on the surface of the SOI substrate 90 is patterned to leave a region of the first silicon layer 91 where the pn junction diode 67 is to be formed. Then, the pn junction diode 67 is formed in the first silicon layer 91 on the basis of a known method (see Fig. 33B).

[Step-110]

Thereafter, the wiring line 68 and the signal line 51 are formed on the SiO$_2$ layer 92 and a part of the pn junction diode 67 on the basis of a known method (see Fig. 33C). Next, the insulating film 66 including SiO$_2$, the contact hole 53, and the drive line 52 are formed on the entire surface, and then the insulating film 66 is patterned (see Fig. 33D). However, the contact hole 53 and the drive line 52 are not illustrated in Fig. 33D and subsequent drawings.

[Step-120]

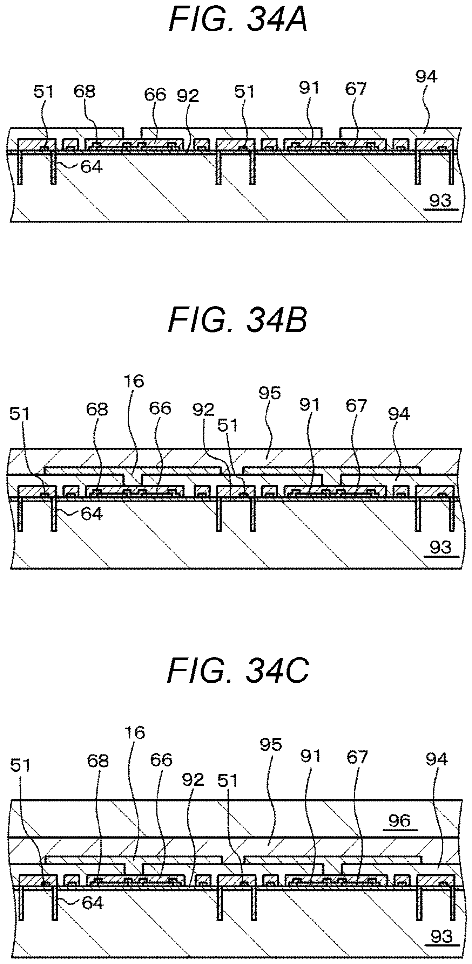

Thereafter, formation of a first sacrificial layer 94 (see Fig. 34A), formation of the infrared absorption layer 16, and formation of a second sacrificial layer 95 (see Fig. 34B) are performed, and then a support substrate 96 is pasted to the second sacrificial layer 95 (see Fig. 34C).

[Step-130]

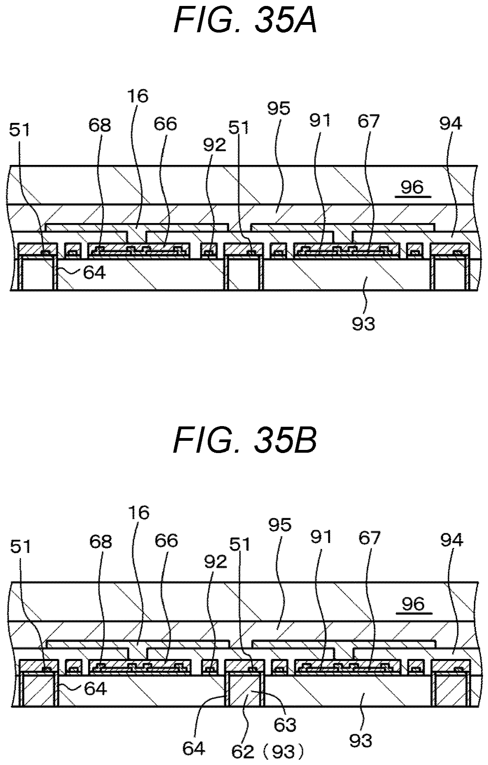

Next, the second silicon layer 93 of the SOI substrate 90 is thinned by a CMP method (see Fig. 35A). The thickness of the second silicon layer 93 defines $L_0$. Thus, it is possible to accurately define a value of $L_0$. The structure illustrated in Fig. 35B can be obtained in this way; however, the second silicon layer 93 in the inner portion of the side wall 64 corresponds to the partition wall 63, and for convenience, the hatching in this portion is different from the hatching in the second silicon layer 93.

[Step-140]

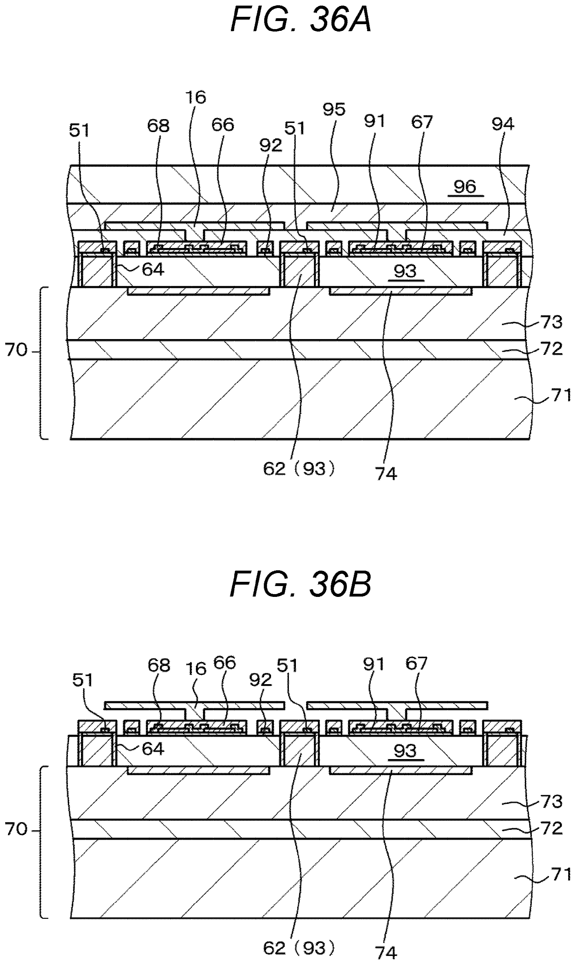

The second structural body 70 provided with the drive circuit is prepared. Note that, the infrared reflection layer 74 is formed on the coating layer 73. Then, the second silicon layer 93 and the coating layer 73 are bonded together by a known method (see Fig. 36A). Then, in the peripheral regions 12 and 14, the drive line 52 and the signal line 51 are electrically connected to the drive circuit by, for example, a through silicon via (TSV) not illustrated.

[Step-150]

Thereafter, the support substrate 96 is removed, and the second sacrificial layer 95 and the first sacrificial layer 94 are removed on the basis of an etching method (see Fig. 36B). Moreover, the second silicon layer 93 positioned below the pn junction diode 67 is removed by the etching method. In this way, the imaging device 10 illustrated in Fig. 1A can be obtained. The $SiO_2$ layer 92 forms the diaphragm portion 65A, the insulating material layer 65B, the first stud portion 65C, and the second stud portion 65D. Note that, not all of the second silicon layer 93 positioned below the pn junction diode 67 may be removed.

Thereafter, the obtained imaging device 10 is packaged under a vacuum atmosphere. As a result, a space where the temperature detection element 15 is arranged is decompressed or made to be in a vacuum. The void 69 is also decompressed or made to be in a vacuum.

In the imaging device of Example 10, the first substrate is bonded to the coating layer formed on the second substrate, and the silicon layer positioned below the temperature detection element is surrounded by the coating layer and the side wall of the partition wall that are less likely to be etched than the silicon layer. Thus, it is possible to provide a void reliably and highly accurately between the temperature detection element and the coating layer. As a result, for example, infrared rays having a desired wavelength can be reliably absorbed in the infrared absorption layer with high efficiency, and the detection sensitivity of the temperature detection element can be improved. Furthermore. It becomes possible to combine the second structural body provided with any known drive circuit and signal processing circuit, so that it is possible to reduce the manufacturing cost of the imaging device, improve the design flexibility, and shorten the design time, and becomes possible to reduce the number of input and output pins and reduce the input and output signal band.

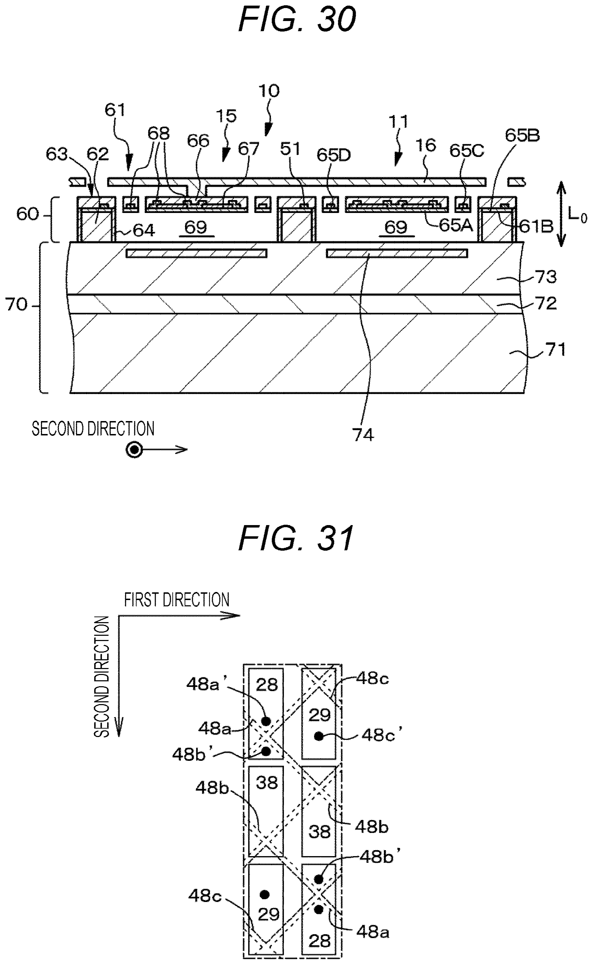

A modification of the imaging device of Example 10 illustrated in Fig. 27 is illustrated in Fig. 30, and the infrared reflection layer 74 is formed inside the coating layer 73.

[Example 11]

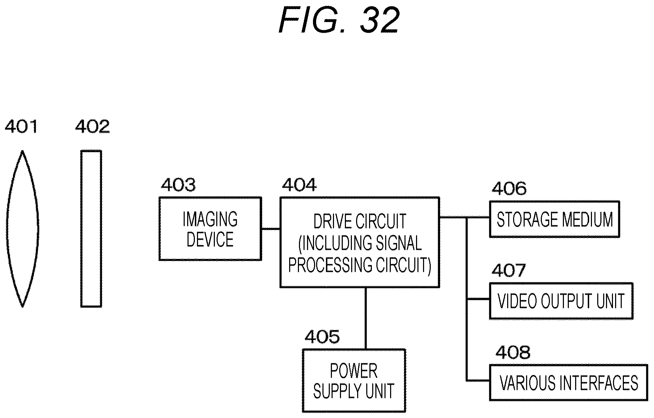

In Example 11, an example will be described in which the imaging device described in Examples 1 to 10 is applied to an infrared camera. As illustrated in a conceptual diagram in Fig. 32, the infrared camera includes a lens 401, a shutter 402, an imaging device 403 described in Examples 1 to 10, a drive circuit 404, a power supply unit 405, a storage medium 406, a video output unit 407, and various interfaces 408. In addition to the various circuits described above, the drive circuit 404 includes, for example, a signal processing circuit that corrects variations between pixels, corrects defective pixels, and performs various types of noise removal. The components of the infrared camera having such a configuration can be known components except the imaging device 403, and thus detailed description thereof will be omitted.

Although the imaging device of the present disclosure has been described above on the basis of preferable examples, the imaging device of the present disclosure is not limited to these examples. The configurations and structures of the imaging device, the temperature detection element, and the gain measuring element described in the examples are exemplifications and can be changed as appropriate, and the materials forming the imaging device, the temperature detection element, and the gain measuring element, and the method of manufacturing the imaging device and the temperature detection element are also exemplifications and can be changed as appropriate. In some cases, formation of the infrared reflection layer may be omitted, and the top surface of the coating layer itself may be caused to function as the infrared reflection layer.

The number of temperature detection elements and infrared absorption layers constituting the temperature detection element unit is essentially arbitrary. As illustrated in Fig. 31, a further modification of Example 5 includes

a plurality of temperature detection element units arranged along a first direction and a second direction different from the first direction, in which
each of the temperature detection element units includes a temperature detection element 28 and a gain measuring element 38 adjacent to each other along any one of the first direction and the second direction (along the second direction in the example illustrated in Fig. 31)
infrared absorption layers 48a and 48b are arranged apart from the temperature detection element 28 and the gain measuring element 38 along an infrared incident direction, and
the infrared absorption layer 48b is thermally connected to the temperature detection element 28 at a connection portion 48b' and is not thermally connected to the gain measuring element 38. The infrared absorption layer 48a is thermally connected to the temperature detection element 28 at a connection portion 48a'. Furthermore,
each of the temperature detection element units includes a temperature detection element 29 and the gain measuring element 38 adjacent to each other along any one of the first direction and the second direction (along the second direction in the example illustrated in Fig. 31),
infrared absorption layers 48c and 48b are arranged apart from the temperature detection element 29 and the gain measuring element 38 along an infrared incident direction, and
the infrared absorption layer 48c is thermally connected to the temperature detection element 29 at a connection portion 48c' and is not thermally connected to the gain measuring element 38. The infrared absorption layer 48b is thermally connected to the temperature detection element 28 adjacent along the second direction at the connection portion 48b' and is not thermally connected to the gain measuring element 38.

As the planar shape of the first infrared absorption layer and the second infrared absorption layer, or as the planar shape of the infrared absorption layer, a quadrangle including a rectangle such as a square or an oblong (see Example 1, Example 3, Example 4, Example 5, Example 7, Example 8, Example 9), rhombus (see Example 2, the modifications of Example 5), a combination of polygons (for example, a combination of an octagon and a quadrangle, see the modification of Example 2, the modifications of Example 5, Example 6) have been mentioned; however, the planar shape of these first infrared absorption layer and second infrared absorption layer or the infrared absorption layer is not limited to these, and it may be a polygon (for example, a hexagon).

A light focusing element including, for example, a lens and the like may be arranged on the infrared incident side of the imaging device. Specifically, a light focusing element (lens) may be provided on the infrared incident side of a protective substrate including a silicon semiconductor substrate attached to the side of the surface of the first substrate 61 (the second surface 61B of the first substrate 61). The light focusing element may be formed including a member (for example, a resist material) different from the protective substrate, or the light focusing element may be formed by performing etching processing on the protective substrate. The light focusing element can be formed, for example, by a method similar to the known method of forming an on-chip micro lens. Instead of the protective substrate including the silicon semiconductor substrate, for example, a protective substrate can be used including a material that transmits infrared rays, such as $CaF_2$, $BaF_2$, $Al_2O_3$, or ZnSe.

Furthermore, a light shielding portion may be provided on the infrared incident side of the imaging device to suppress incidence of infrared rays into the adjacent temperature detection element. The light shielding portion can be formed, for example, by forming a groove portion in the protective substrate and filling the groove portion with a metal material or an alloy material.

Furthermore, a temperature detection element can also be configured from one of the temperature detection elements constituting the imaging device of the present disclosure, and an imaging device can also be made in which the temperature detection elements constituting the imaging device of the present disclosure are one-dimensionally arranged. That is, broadly, an imaging device of the present disclosure can also be made in which Q (where $Q \geq 1$) temperature detection elements constituting the imaging device of the present disclosure are one-dimensionally arranged, in other words, that includes one-dimensionally arranged Q (where $Q \geq 1$) temperature detection elements.

A mode can also be made in which the infrared absorption layer corresponding to the temperature detection element positioned in the central portion of the temperature detection element array is horizontally arranged, and the infrared absorption layer corresponding to the temperature detection element positioned in the peripheral portion of the temperature detection element array is inclined toward the central portion of the temperature detection element array, and this also makes it possible to provide an imaging device in which variations are small in temperature detection depending on the arrangement position of the temperature detection elements. Such a mode can be combined with Example 8 or 9.

The signal processing circuit can include fixed pattern noise correction processing by measuring noise in advance, noise reduction processing based on a noise model, and resolution correction processing based on a lens imaging model. Furthermore, it is also possible to synthesize an image obtained from the infrared camera and an image captured on the basis of normal visible light. An outline of various types of signal processing will be described below, but the signal processing is not limited to these.

As the fixed pattern noise correction processing, for example, processing can be mentioned such that difference data is generated corresponding to a difference between fixed pattern noise data obtained in a previous imaging frame and fixed pattern noise data obtained in a current imaging frame, and the difference data and the fixed pattern noise data obtained in the previous imaging frame are added together to obtain new fixed pattern noise data.

Furthermore, as noise reduction processing using an infinite impulse response (IIR) type filter, for example, noise reduction processing can be mentioned that includes:

a first step of calculating an average value of signal values of reference pixels in the vicinity of a pixel to be corrected, by IIR filter processing;

a second step of calculating a variance value of the signal values of the reference pixels in the vicinity of the pixel to be corrected, by IIR filter processing;

a third step of inputting the average value and the variance value of the reference pixels and executing the edge-preserving smoothing processing to which the average value and the variance value are applied; and

a fourth step of updating IIR filter coefficients applied in the first step and the second step depending on a signal value of a pixel constituting an image.

Furthermore, as the resolution correction processing, a method can be mentioned of acquiring a filter for performing blur correction set for each of a plurality of image heights, and correcting a pixel value of a pixel at an image height to be corrected by using the acquired filter. Here, the correction can be processing of applying a filter set for an image height adjacent to the image height to be corrected to the pixel value of the pixel to be corrected, calculating coefficients from a positional relationship between the adjacent image height and the image height to be corrected, and calculating a corrected pixel value by using the pixel value after the filter application and the coefficients. Alternatively, the correction can be processing of calculating coefficients from a positional relationship between the adjacent image height and the image height to be corrected, generating a filter to be applied to the pixel value of the pixel to be corrected by using a filter set for the image height adjacent to the image height to be corrected, and the coefficients, and calculating a corrected pixel value by using the generated filter and the pixel value of the pixel to be corrected. Moreover, the filter coefficients can be coefficients calculated from an approximated Point Spread Function (PSF) data obtained by calculating PSF data from a plurality of image points on a first image height, averaging the PSF data, and approximating the averaged PSF data by a predetermined function, and a Wiener filter can be used for calculation of the filter coefficients.

REFERENCE SIGNS LIST

10, 10A Imaging device
11 Temperature detection element array region
13 Central region
12, 14 Peripheral region
15 Temperature detection element
16 Infrared absorption layer
20A, 20B Temperature detection element unit
21, $21_{11}$, $21_{12}$ First temperature detection element
$21_1$ First A region of first temperature detection element
$21_2$ First B region of first temperature detection element
22, $22_{11}$, $22_{12}$ Second temperature detection element
$22_1$ Second A region of second temperature detection element
$22_2$ Second B region of second temperature detection element
23, 24a, 24b, 25a, 26a, 27a, 27b, 121, 122, 123, 124, 125, 126, 127, 128, 221, 321 Temperature detection element
$121_1$ First A region of first temperature detection element

$121_2$ First B region of first temperature detection element

$122_1$ Second A region of second temperature detection element

$122_2$ Second B region of second temperature detection element

$123_1$ Third A region of third temperature detection element

$123_2$ Third B region of third temperature detection element

$124_1$ Fourth A region of fourth temperature detection element

$124_2$ Fourth B region of fourth temperature detection element

$125_1$ Fifth A region of fifth temperature detection element

$125_2$ Fifth B region of fifth temperature detection element

$126_1$ Sixth A region of sixth temperature detection element

$126_2$ Sixth B region of sixth temperature detection element

$127_1$ Seventh A region of seventh temperature detection element

$127_2$ Seventh B region of seventh temperature detection element

$128_1$ Eighth A region of eighth temperature detection element

$128_2$ Eighth B region of eighth temperature detection element

25c, 26c Temperature detection element-A

25d, 26d Temperature detection element-B

31, 31R, 31L, 33, 34b, 35a, 36a Gain measuring element

40A, 40B Infrared absorption layer unit

41 First infrared absorption layer

42 Second infrared absorption layer

43, 44a, 47a, 47b, 241, 341 Infrared absorption layer

$44b_1$, 45a, 46a First infrared absorption layer

$44b_2$, 45b, 46b Second infrared absorption layer

45c, 46c Infrared absorption layer-A

45d, 46d Infrared absorption layer-B

41', 42', 43', 44a', $44b_1$', 45a', 45b', 45c', 45d', 46c', 46d' Connection portion

$44b_2$', 46b' Support portion

51, $51_1$, $51_2$, $51_3$, $51_4$ Signal line

52, $52_1$, $52_2$ Drive line

53 Contact hole

60 First structural body

61 First substrate

61B First substrate's second surface

62 Silicon layer

63 Partition wall

64 Side wall of partition wall

65A Diaphragm portion (aerial portion, aerial thin layer portion)

65B Insulating material layer

65C First stud portion

65D Second stud portion

66 Insulating film

67 pn junction diode

68 Wiring line

69 Void

70 Second structural body

71 Second substrate

72 Layer in which drive circuit is formed

73 Coating layer (interlayer insulating layer)

74 Infrared reflection layer

81 Vertical scanning circuit

82 Constant current circuit

83 Analog front end (AFE)

84 Sample hold circuit

85 Analog-digital conversion circuit (ADC)

86 Horizontal scanning circuit

90 SOI substrate

91 First silicon layer

92 SiO$_2$ layer
93 Second silicon layer
94 First sacrificial layer
95 Second sacrificial layer
96 Support substrate
401 Lens
402 Shutter
403 Imaging device
404 Drive circuit
405 Power supply unit
406 Storage medium
407 Video output unit
408 Various interfaces

**Claims**

1. An imaging device (10) comprising:

   a plurality of temperature detection element units (20A, 20B) arranged along a first direction and a second direction different from the first direction; and
   a plurality of infrared absorption layer units (40A, 40B) arranged along the first direction and the second direction, wherein
   each of the temperature detection element units (20A, 20B) includes a first temperature detection element (21) and a second temperature detection element (22) adjacent to each other along the first direction,
   each of the infrared absorption layer units (40A, 40B) includes a first infrared absorption layer (41) and a second infrared absorption layer (42) adjacent to each other along the second direction,
   the first temperature detection element (21) includes a first A region (21$_1$), and a first B region (21$_2$) in contact with the first A region (21$_1$) along the second direction,
   the second temperature detection element (22) includes a second A region (22$_1$), and a second B region (22$_2$) in contact with the second A region (22$_1$) along the second direction,
   the first infrared absorption layer (41) is arranged apart from the first A region (21$_1$) and the second A region (22$_1$) along an infrared incident direction, and is thermally connected to the first temperature detection element (21), and
   the second infrared absorption layer (42) is arranged apart from the first B region (21$_2$) and the second B region (22$_2$) along the infrared incident direction, and is thermally connected to the second temperature detection element (22).

2. The imaging device (10) according to claim 1, wherein

   an orthographic image of the first infrared absorption layer (41) overlaps at least a part of the first A region (21$_1$) and a part of the second A region (22$_2$), and
   an orthographic image of the second infrared absorption layer (42) overlaps at least a part of the first B region (21$_2$) and a part of the second B region (22$_2$).

3. The imaging device (10) according to claim 2, wherein

   the orthographic image of the first infrared absorption layer (41) overlaps the first A region (21$_1$) and the second A region (22$_1$), and
   the orthographic image of the second infrared absorption layer (42) overlaps the first B region (21$_1$) and the second B region (22$_2$).

4. The imaging device (10) according to any one of claims 1 to 3, wherein the first infrared absorption layer (41) and the second infrared absorption layer (42) coat the first temperature detection element and the second temperature detection element substantially without a gap between the first and the second infrared absorption layers (41, 42).

5. The imaging device (10) according to any one of claims 1 to 3, wherein a gain measuring element (31) is arranged between the temperature detection element units (20A, 20B).

6. The imaging device (10) according to claim 5, wherein the first infrared absorption layer (41) and the second infrared absorption layer (42) coat the first temperature detection element (21) and the second temperature detection element (22) substantially without a gap between the first and the second infrared absorption layers (41, 42), and does not coat the gain measuring element (31),

or wherein the first infrared absorption layer (41) and the second infrared absorption layer (42) coat the first temperature detection element (21), the second temperature detection element (22), and the gain measuring element (31) substantially without a gap between the first and the second infrared absorption layers (41, 42).

7. An imaging device (10) comprising:

a plurality of temperature detection element units arranged along a first direction and a second direction different from the first direction; and
a plurality of infrared absorption layer units arranged along the first direction and the second direction, wherein each of the temperature detection element units includes a first temperature detection element unit and a second temperature detection element unit arranged together with the first temperature detection element unit along the first direction,
each of the first temperature detection element unit and the second temperature detection element unit includes a plurality of temperature detection elements (121, 122, 123, 124; 125, 126, 127, 128) arranged along the first direction and the second direction,
each of the infrared absorption layer units includes a first infrared absorption layer unit arranged apart from the first temperature detection element unit along an infrared incident direction, and a second infrared absorption layer unit arranged apart from the second temperature detection element unit along the infrared incident direction,
the first infrared absorption layer unit includes a plurality of infrared absorption layers (141, 142, 143, 144) extending along the second direction and arranged side by side along the first direction,
one of the temperature detection elements constituting the first temperature detection element unit is thermally connected to one of the infrared absorption layers constituting the first infrared absorption layer unit,
the second infrared absorption layer unit includes a plurality of infrared absorption layers (145, 146, 147, 148) extending along the first direction and arranged side by side along the second direction, and
one of the temperature detection elements constituting the second temperature detection element unit is thermally connected to one of the infrared absorption layers constituting the second infrared absorption layer unit.

8. The imaging device according to claim 7, wherein the first temperature detection element unit and the second temperature detection element unit are arranged in a checkerboard pattern along the first direction and the second direction.

9. The imaging device according to claim 7 or 8, wherein

the first temperature detection element unit includes a first temperature detection element (121) and a second temperature detection element (122) arranged along the first direction, and, along the second direction, a third temperature detection element (123) arranged adjacent to the first temperature detection element (121), and a fourth temperature detection element (124) arranged adjacent to the second temperature detection element (122),
the second temperature detection element unit includes a fifth temperature detection element (125) and a sixth temperature detection element (126) arranged along the first direction, and, along the second direction, a seventh temperature detection element (127) arranged adjacent to the fifth temperature detection element (125), and an eighth temperature detection element (128) arranged adjacent to the sixth temperature detection element (126),
the first temperature detection element (121) includes a first A region ($121_1$), and a first B region ($121_2$) in contact with the first A region ($121_1$) along the second direction,
the second temperature detection element (122) includes a second A region ($122_1$), and a second B ($122_2$) region in contact with the second A region ($122_1$) along the second direction,
the third temperature detection element (123) includes a third A region ($123_1$), and a third B region ($123_2$) in contact with the third A region ($123_1$) along the second direction,
the fourth temperature detection element (124) includes a fourth A region ($124_1$), and a fourth B region ($124_2$) in contact with the fourth A region ($124_1$) along the second direction,
the fifth temperature detection element (125) includes a fifth A region ($125_1$), and a fifth B region ($125_2$) in contact with the fifth A region ($125_1$) along the first direction,
the sixth temperature detection element (126) includes a sixth A region ($126_1$), and a sixth B region ($126_2$) in

contact with the sixth A region ($126_1$) along the first direction,

the seventh temperature detection element (127) includes a seventh A region ($127_1$), and a seventh B region ($127_2$) in contact with the seventh A region ($127_1$) along the first direction,

the eighth temperature detection element (128) includes an eighth A region ($128_1$), and an eighth B region ($128_2$) in contact with the eighth A region ($128_1$) along the first direction,

the first infrared absorption layer unit includes a first infrared absorption layer (141), a second infrared absorption layer (142), a third infrared absorption layer (143), and a fourth infrared absorption layer (144),

the second infrared absorption layer unit includes a fifth infrared absorption layer (145), a sixth infrared absorption layer (146), a seventh infrared absorption layer (147), and an eighth infrared absorption layer (148),

the first infrared absorption layer (141) is arranged apart from the first A region ($121_1$) and the second A region ($122_1$) along the infrared incident direction, and is thermally connected to the first temperature detection element (121),

the second infrared absorption layer (142) is arranged apart from the first B region ($121_1$) and the second B region ($122_2$) along the infrared incident direction, and is thermally connected to the second temperature detection element (122),

the third infrared absorption layer (143) is arranged apart from the third A region ($123_1$) and the fourth A region ($124_1$) along the infrared incident direction, and is thermally connected to the third temperature detection element (123),

the fourth infrared absorption layer (144) is arranged apart from the third B region ($123_2$) and the fourth B region ($124_2$) along the infrared incident direction, and is thermally connected to the fourth temperature detection element (124),

the fifth infrared absorption layer (145) is arranged apart from the fifth A region ($125_1$) and the sixth A region ($126_1$) along the infrared incident direction, and is thermally connected to the fifth temperature detection element (125),

the sixth infrared absorption layer (146) is arranged apart from the fifth B region ($125_2$) and the sixth B region ($126_2$) along the infrared incident direction, and is thermally connected to the sixth temperature detection element (126),

the seventh infrared absorption layer (147) is arranged apart from the seventh A region ($127_1$) and the eighth A region ($128_1$) along the infrared incident direction, and is thermally connected to the seventh temperature detection element (127), and

the eighth infrared absorption layer (148) is arranged apart from the seventh B region ($127_2$) and the eighth B region ($128_2$) along the infrared incident direction, and is thermally connected to the eighth temperature detection element (128).

**Patentansprüche**

1. Bildgebungsvorrichtung (10), umfassend:

eine Vielzahl von Temperaturerfassungselementeinheiten (20A, 20B), die entlang einer ersten Richtung und einer zweiten Richtung, die sich von der ersten Richtung unterscheidet, angeordnet sind; und

eine Vielzahl von Infrarotabsorptionsschichteinheiten (40A, 40B), die entlang der ersten Richtung und der zweiten Richtung angeordnet sind, wobei

jede der Temperaturerfassungselementeinheiten (20A, 20B) ein erstes Temperaturerfassungselement (21) und ein zweites Temperaturerfassungselement (22), die entlang der ersten Richtung aneinander angrenzen, einschließt,

jede der Infrarotabsorptionsschichteinheiten (40A, 40B) eine erste Infrarotabsorptionsschicht (41) und eine zweite Infrarotabsorptionsschicht (42), die entlang der zweiten Richtung aneinander angrenzen, einschließt,

das erste Temperaturerfassungselement (21) einen ersten A-Bereich ($21_1$) und einen ersten B-Bereich ($21_2$), der in Kontakt mit dem ersten A-Bereich ($21_1$) entlang der zweiten Richtung ist, einschließt,

das zweite Temperaturerfassungselement (22) einen zweiten A-Bereich ($22_1$) und einen zweiten B-Bereich ($22_2$), der in Kontakt mit dem zweiten A-Bereich ($22_1$) entlang der zweiten Richtung ist, einschließt,

die erste Infrarotabsorptionsschicht (41) von dem ersten A-Bereich ($21_1$) und dem zweiten A-Bereich ($22_1$) entlang einer Infraroteinfallsrichtung getrennt angeordnet ist und thermisch mit dem ersten Temperaturerfassungselement (21) verbunden ist, und

die zweite Infrarotabsorptionsschicht (42) von dem ersten B-Bereich ($21_2$) und dem zweiten B-Bereich ($22_2$) entlang der Infraroteinfallsrichtung getrennt angeordnet ist und thermisch mit dem zweiten Temperaturerfassungselement (22) verbunden ist.

2. Bildgebungsvorrichtung (10) nach Anspruch 1, wobei ein orthografisches Bild der ersten Infrarotabsorptionsschicht (41) mindestens einen Teil des ersten A-Bereichs ($21_1$) und einen Teil des zweiten A-Bereichs ($22_2$) überlappt und ein orthografisches Bild der zweiten Infrarotabsorptionsschicht (42) mindestens einen Teil des ersten B-Bereichs ($21_2$) und einen Teil des zweiten B-Bereichs ($22_2$) überlappt.

3. Bildgebungsvorrichtung (10) nach Anspruch 2, wobei das orthografische Bild der ersten Infrarotabsorptionsschicht (41) den ersten A-Bereich ($21_1$) und den zweiten A-Bereich ($22_1$) überlappt und

   das orthografische Bild der zweiten Infrarotabsorptionsschicht (42) den ersten B-Bereich ($21_1$) und den zweiten B-Bereich ($22_2$) überlappt.

4. Bildgebungsvorrichtung (10) nach einem der Ansprüche 1 bis 3, wobei die erste Infrarotabsorptionsschicht (41) und die zweite Infrarotabsorptionsschicht (42) das erste Temperaturerfassungselement und das zweite Temperaturerfassungselement im Wesentlichen ohne einen Spalt zwischen der ersten und der zweiten Infrarotabsorptionsschicht (41, 42) beschichten.

5. Bildgebungsvorrichtung (10) nach einem der Ansprüche 1 bis 3, wobei ein Verstärkungsmesselement (31) zwischen den Temperaturerfassungselementeinheiten (20A, 20B) angeordnet ist.

6. Bildgebungsvorrichtung (10) nach Anspruch 5, wobei die erste Infrarotabsorptionsschicht (41) und die zweite Infrarotabsorptionsschicht (42) das erste Temperaturerfassungselement (21) und das zweite Temperaturerfassungselement (22) im Wesentlichen ohne einen Spalt zwischen der ersten und der zweiten Infrarotabsorptionsschicht (41, 42) beschichten und das Verstärkungsmesselement (31) nicht beschichten,

   oder wobei die erste Infrarotabsorptionsschicht (41) und die zweite Infrarotabsorptionsschicht (42) das erste Temperaturerfassungselement (21), das zweite Temperaturerfassungselement (22) und das Verstärkungsmesselement (31) im Wesentlichen ohne einen Spalt zwischen der ersten und der zweiten Infrarotabsorptionsschicht (41, 42) beschichten.

7. Bildgebungsvorrichtung (10), umfassend:

   eine Vielzahl von Temperaturerfassungselementeinheiten, die entlang einer ersten Richtung und einer zweiten Richtung, die sich von der ersten Richtung unterscheidet, angeordnet sind; und
   eine Vielzahl von Infrarotabsorptionsschichteinheiten, die entlang der ersten Richtung und der zweiten Richtung angeordnet sind, wobei
   jede der Temperaturerfassungselementeinheiten eine erste Temperaturerfassungseinheit und eine zweite Temperaturerfassungseinheit einschließt, die zusammen mit der ersten Temperaturerfassungseinheit entlang der ersten Richtung angeordnet ist,
   jede der ersten Temperaturerfassungseinheit und der zweiten Temperaturerfassungseinheit eine Vielzahl von Temperaturerfassungselementen (121, 122, 123, 124; 125, 126, 127, 128) einschließt, die entlang der ersten Richtung und der zweiten Richtung angeordnet sind,
   jede der Infrarotabsorptionsschichteinheiten eine erste Infrarotabsorptionsschichteinheit, die entlang einer Infraroteinfallsrichtung von der ersten Temperaturerfassungseinheit getrennt angeordnet ist, und eine zweite Infrarotabsorptionsschichteinheit einschließt, die entlang der Infraroteinfallsrichtung von der zweiten Temperaturerfassungseinheit getrennt angeordnet ist,
   die erste Infrarotabsorptionsschichteinheit eine Vielzahl von Infrarotabsorptionsschichten (141, 142, 143, 144) einschließt, die sich entlang der zweiten Richtung erstrecken und nebeneinander entlang der ersten Richtung angeordnet sind,
   eines der Temperaturerfassungselemente, die die erste Temperaturerfassungseinheit bilden, thermisch mit einer der Infrarotabsorptionsschichten verbunden ist, die die erste Infrarotabsorptionsschichteinheit bilden,
   die zweite Infrarotabsorptionsschichteinheit eine Vielzahl von Infrarotabsorptionsschichten (145, 146, 147, 148) einschließt, die sich entlang der ersten Richtung erstrecken und nebeneinander entlang der zweiten Richtung angeordnet sind, und
   eines der Temperaturerfassungselemente, die die zweite Temperaturerfassungseinheit bilden, thermisch mit einer der Infrarotabsorptionsschichten verbunden ist, die die zweite Infrarotabsorptionsschichteinheit bilden.

8. Bildgebungsvorrichtung nach Anspruch 7, wobei die erste Temperaturerfassungseinheit und die zweite Temperaturerfassungseinheit in einem Schachbrettmuster entlang der ersten Richtung und der zweiten Richtung angeordnet sind.

9.  Bildgebungsvorrichtung nach Anspruch 7 oder 8, wobei

die erste Temperaturerfassungseinheit ein erstes Temperaturerfassungselement (121) und ein zweites Temperaturerfassungselement (122), die entlang der ersten Richtung angeordnet sind, und entlang der zweiten Richtung ein drittes Temperaturerfassungselement (123), das angrenzend an das erste Temperaturerfassungselement (121) angeordnet ist, und ein viertes Temperaturerfassungselement (124), das angrenzend an das zweite Temperaturerfassungselement (122) angeordnet ist, einschließt,

die zweite Temperaturerfassungseinheit ein fünftes Temperaturerfassungselement (125) und ein sechstes Temperaturerfassungselement (126), die entlang der ersten Richtung angeordnet sind, und entlang der zweiten Richtung ein siebtes Temperaturerfassungselement (127), das angrenzend an das fünfte Temperaturerfassungselement (125) angeordnet ist, und ein achtes Temperaturerfassungselement (128), das angrenzend an das sechste Temperaturerfassungselement (126) angeordnet ist, einschließt,

das erste Temperaturerfassungselement (121) einen ersten A-Bereich ($121_1$) und einen ersten B-Bereich ($121_2$), der in Kontakt mit dem ersten A-Bereich ($121_1$) entlang der zweiten Richtung ist, einschließt,

das zweite Temperaturerfassungselement (122) einen zweiten A-Bereich ($122_1$) und einen zweiten B-Bereich ($122_2$), der in Kontakt mit dem zweiten A-Bereich ($122_1$) entlang der zweiten Richtung ist, einschließt,

das dritte Temperaturerfassungselement (123) einen dritten A-Bereich ($123_1$) und einen dritten B-Bereich ($123_2$), der in Kontakt mit dem dritten A-Bereich ($123_1$) entlang der zweiten Richtung ist, einschließt,

das vierte Temperaturerfassungselement (124) einen vierten A-Bereich ($124_1$) und einen vierten B-Bereich ($124_2$), der in Kontakt mit dem vierten A-Bereich ($124_1$) entlang der zweiten Richtung ist, einschließt,

das fünfte Temperaturerfassungselement (125) einen fünften A-Bereich ($125_1$) und einen fünften B-Bereich ($125_2$), der in Kontakt mit dem fünften A-Bereich ($125_1$) entlang der ersten Richtung ist, einschließt,

das sechste Temperaturerfassungselement (126) einen sechsten A-Bereich ($126_1$) und einen sechsten B-Bereich ($126_2$), der in Kontakt mit dem sechsten A-Bereich ($126_1$) entlang der ersten Richtung ist, einschließt,

das siebte Temperaturerfassungselement (127) einen siebten A-Bereich ($127_1$) und einen siebten B-Bereich ($127_2$), der in Kontakt mit dem siebten A-Bereich ($127_1$) entlang der ersten Richtung ist, einschließt,

das achte Temperaturerfassungselement (128) einen achten A-Bereich ($128_1$) und einen achten B-Bereich ($128_2$), der in Kontakt mit dem achten A-Bereich ($128_1$) entlang der ersten Richtung ist, einschließt,

die erste Infrarotabsorptionsschichteinheit eine erste Infrarotabsorptionsschicht (141), eine zweite Infrarotabsorptionsschicht (142), eine dritte Infrarotabsorptionsschicht (143) und eine vierte Infrarotabsorptionsschicht (144) einschließt,

die zweite Infrarotabsorptionsschichteinheit eine fünfte Infrarotabsorptionsschicht (145), eine sechste Infrarotabsorptionsschicht (146), eine siebte Infrarotabsorptionsschicht (147) und eine achte Infrarotabsorptionsschicht (148) einschließt,

die erste Infrarotabsorptionsschicht (141) von dem ersten A-Bereich ($121_1$) und dem zweiten A-Bereich ($122_1$) entlang der Infraroteinfallsrichtung getrennt angeordnet ist und thermisch mit dem ersten Temperaturerfassungselement (121) verbunden ist,

die zweite Infrarotabsorptionsschicht (142) von dem ersten B-Bereich ($121_1$) und dem zweiten B-Bereich ($122_2$) entlang der Infraroteinfallsrichtung getrennt angeordnet ist und thermisch mit dem zweiten Temperaturerfassungselement (122) verbunden ist,

die dritte Infrarotabsorptionsschicht (143) von dem dritten A-Bereich ($123_1$) und dem vierten A-Bereich ($124_1$) entlang der Infraroteinfallsrichtung getrennt angeordnet ist und thermisch mit dem dritten Temperaturerfassungselement (123) verbunden ist,

die vierte Infrarotabsorptionsschicht (144) von dem dritten B-Bereich ($123_2$) und dem vierten B-Bereich ($124_2$) entlang der Infraroteinfallsrichtung getrennt angeordnet ist und thermisch mit dem vierten Temperaturerfassungselement (124) verbunden ist,

die fünfte Infrarotabsorptionsschicht (145) von dem fünften A-Bereich ($125_1$) und dem sechsten A-Bereich ($126_1$) entlang der Infraroteinfallsrichtung getrennt angeordnet ist und thermisch mit dem fünften Temperaturerfassungselement (125) verbunden ist,

die sechste Infrarotabsorptionsschicht (146) von dem fünften B-Bereich ($125_2$) und dem sechsten B-Bereich ($126_2$) entlang der Infraroteinfallsrichtung getrennt angeordnet ist und thermisch mit dem sechsten Temperaturerfassungselement (126) verbunden ist,

die siebte Infrarotabsorptionsschicht (147) von dem siebten A-Bereich ($127_1$) und dem achten A-Bereich ($128_1$) entlang der Infraroteinfallsrichtung getrennt angeordnet ist und thermisch mit dem siebten Temperaturerfassungselement (127) verbunden ist, und

die achte Infrarotabsorptionsschicht (148) von dem siebten B-Bereich ($127_2$) und dem achten B-Bereich ($128_2$) entlang der Infraroteinfallsrichtung entfernt angeordnet ist und thermisch mit dem achten Temperaturerfassungselement (128) verbunden ist.

**Revendications**

1.  Dispositif d'imagerie (10) comprenant :

    une pluralité d'unités d'éléments de détection de température (20A, 20B) agencées le long d'une première direction et d'une seconde direction différente de la première direction ; et
    une pluralité d'unités de couches d'absorption d'infrarouge (40A, 40B) agencées le long de la première direction et de la seconde direction, dans lequel
    chacune des unités d'éléments de détection de température (20A, 20B) comporte un premier élément de détection de température (21) et un deuxième élément de détection de température (22) adjacents l'un à l'autre le long de la première direction,
    chacune des unités de couches d'absorption d'infrarouge (40A, 40B) comporte une première couche d'absorption d'infrarouge (41) et une deuxième couche d'absorption d'infrarouge (42) adjacentes l'une à l'autre le long de la seconde direction,
    le premier élément de détection de température (21) comporte une première région A ($21_1$), et une première région B ($21_2$) en contact avec la première région A ($21_1$) le long de la seconde direction,
    le deuxième élément de détection de température (22) comporte une deuxième région A ($22_1$), et une deuxième région B ($22_2$) en contact avec la deuxième région A ($22_1$) le long de la seconde direction,
    la première couche d'absorption d'infrarouge (41) est agencée à l'écart de la première région A ($21_1$) et de la deuxième région A ($22_1$) le long d'une direction d'incidence d'infrarouge, et est reliée thermiquement au premier élément de détection de température (21), et
    la deuxième couche d'absorption d'infrarouge (42) est agencée à l'écart de la première région B ($21_2$) et de la deuxième région B ($22_2$) le long de la direction d'incidence d'infrarouge, et est reliée thermiquement au deuxième élément de détection de température (22).

2.  Dispositif d'imagerie (10) selon la revendication 1, dans lequel une image orthographique de la première couche d'absorption d'infrarouge (41) chevauche au moins une partie de la première région A ($21_1$) et une partie de la deuxième région A ($22_2$), et
    une image orthographique de la deuxième couche d'absorption d'infrarouge (42) chevauche au moins une partie de la première région B ($21_2$) et une partie de la deuxième région B ($22_2$).

3.  Dispositif d'imagerie (10) selon la revendication 2, dans lequel l'image orthographique de la première couche d'absorption d'infrarouge (41) chevauche la première région A ($21_1$) et la deuxième région A ($22_1$), et
    l'image orthographique de la deuxième couche d'absorption d'infrarouge (42) chevauche la première région B ($21_1$) et la deuxième région B ($22_2$).

4.  Dispositif d'imagerie (10) selon l'une quelconque des revendications 1 à 3, dans lequel la première couche d'absorption d'infrarouge (41) et la deuxième couche d'absorption d'infrarouge (42) revêtent le premier élément de détection de température et le deuxième élément de détection de température sensiblement sans espace entre les première et deuxième couches d'absorption d'infrarouge (41, 42).

5.  Dispositif d'imagerie (10) selon l'une quelconque des revendications 1 à 3, dans lequel un élément de mesure de gain (31) est agencé entre les unités d'éléments de détection de température (20A, 20B).

6.  Dispositif d'imagerie (10) selon la revendication 5, dans lequel la première couche d'absorption d'infrarouge (41) et la deuxième couche d'absorption d'infrarouge (42) revêtent le premier élément de détection de température (21) et le deuxième élément de détection de température (22) sensiblement sans espace entre les première et deuxième couches d'absorption d'infrarouge (41, 42), et ne revêtent pas l'élément de mesure de gain (31),
    ou dans lequel la première couche d'absorption d'infrarouge (41) et la deuxième couche d'absorption d'infrarouge (42) revêtent le premier élément de détection de température (21), le deuxième élément de détection de température (22) et l'élément de mesure de gain (31) sensiblement sans espace entre les première et deuxième couches d'absorption d'infrarouge (41, 42).

7.  Dispositif d'imagerie (10) comprenant :

    une pluralité d'unités d'éléments de détection de température agencées le long d'une première direction et d'une seconde direction différente de la première direction ; et
    une pluralité d'unités de couches d'absorption d'infrarouge agencées le long de la première direction et de la seconde direction, dans lequel

chacune des unités d'éléments de détection de température comporte une première unité d'éléments de détection de température et une seconde unité d'éléments de détection de température agencée conjointement avec la première unité d'éléments de détection de température le long de la première direction,

chacune de la première unité d'éléments de détection de température et de la seconde unité d'éléments de détection de température comporte une pluralité d'éléments de détection de température (121, 122, 123, 124 ; 125, 126, 127, 128) agencés le long de la première direction et de la seconde direction,

chacune des unités de couches d'absorption d'infrarouge comporte une première unité de couches d'absorption d'infrarouge agencée à l'écart de la première unité d'éléments de détection de température le long d'une direction d'incidence d'infrarouge, et une seconde unité de couches d'absorption d'infrarouge agencée à l'écart de la seconde unité d'éléments de détection de température le long de la direction d'incidence d'infrarouge,

la première unité de couches d'absorption d'infrarouge comporte une pluralité de couches d'absorption d'infrarouge (141, 142, 143, 144) s'étendant le long de la seconde direction et agencées côte à côte le long de la première direction,

l'un des éléments de détection de température constituant la première unité d'éléments de détection de température est relié thermiquement à l'une des couches d'absorption d'infrarouge constituant la première unité de couches d'absorption d'infrarouge,

la seconde unité de couches d'absorption d'infrarouge comporte une pluralité de couches d'absorption d'infrarouge (145, 146, 147, 148) s'étendant le long de la première direction et agencées côte à côte le long de la seconde direction, et

l'un des éléments de détection de température constituant la seconde unité d'éléments de détection de température est relié thermiquement à l'une des couches d'absorption d'infrarouge constituant la seconde unité de couches d'absorption d'infrarouge.

8. Dispositif d'imagerie selon la revendication 7, dans lequel la première unité d'éléments de détection de température et la seconde unité d'éléments de détection de température sont agencées dans un motif à damier le long de la première direction et de la seconde direction.

9. Dispositif d'imagerie selon la revendication 7 ou 8, dans lequel

la première unité d'éléments de détection de température comporte un premier élément de détection de température (121) et un deuxième élément de détection de température (122) agencés le long de la première direction et, le long de la seconde direction, un troisième élément de détection de température (123) agencé adjacent au premier élément de détection de température (121) et un quatrième élément de détection de température (124) agencé adjacent au deuxième élément de détection de température (122),

la seconde unité d'éléments de détection de température comporte un cinquième élément de détection de température (125) et un sixième élément de détection de température (126) agencés le long de la première direction et, le long de la seconde direction, un septième élément de détection de température (127) agencé adjacent au cinquième élément de détection de température (125) et un huitième élément de détection de température (128) agencé adjacent au sixième élément de détection de température (126),

le premier élément de détection de température (121) comporte une première région A ($121_1$) et une première région B ($121_2$) en contact avec la première région A ($121_1$) le long de la seconde direction,

le deuxième élément de détection de température (122) comporte une deuxième région A ($122_1$) et une deuxième région B ($122_2$) en contact avec la deuxième région A ($122_1$) le long de la seconde direction,

le troisième élément de détection de température (123) comporte une troisième région A ($123_1$) et une troisième région B ($123_2$) en contact avec la troisième région A ($123_1$) le long de la seconde direction,

le quatrième élément de détection de température (124) comporte une quatrième région A ($124_1$) et une quatrième région B ($124_2$) en contact avec la quatrième région A ($124_1$) le long de la seconde direction,

le cinquième élément de détection de température (125) comporte une cinquième région A ($125_1$) et une cinquième région B ($125_2$) en contact avec la cinquième région A ($125_1$) le long de la première direction,

le sixième élément de détection de température (126) comporte une sixième région A ($126_1$) et une sixième région B ($126_2$) en contact avec la sixième région A ($126_1$) le long de la première direction,

le septième élément de détection de température (127) comporte une septième région A ($127_1$) et une septième région B ($127_2$) en contact avec la septième région A ($127_1$) le long de la première direction,

le huitième élément de détection de température (128) comporte une huitième région A ($128_1$) et une huitième région B ($128_2$) en contact avec la huitième région A ($128_1$) le long de la première direction,

la première unité de couches d'absorption d'infrarouge comporte une première couche d'absorption d'infrarouge (141), une deuxième couche d'absorption d'infrarouge (142), une troisième couche d'absorption d'infrarouge (143) et une quatrième couche d'absorption d'infrarouge (144),

la seconde unité de couches d'absorption d'infrarouge comporte une cinquième couche d'absorption d'infrarouge (145), une sixième couche d'absorption d'infrarouge (146), une septième couche d'absorption d'infrarouge (147) et une huitième couche d'absorption d'infrarouge (148),

la première couche d'absorption d'infrarouge (141) est agencée à l'écart de la première région A ($121_1$) et de la deuxième région A ($122_1$) le long de la direction d'incidence d'infrarouge et est reliée thermiquement au premier élément de détection de température (121),

la deuxième couche d'absorption d'infrarouge (142) est agencée à l'écart de la première région B ($121_1$) et de la deuxième région B ($122_2$) le long de la direction d'incidence d'infrarouge et est reliée thermiquement au deuxième élément de détection de température (122),

la troisième couche d'absorption d'infrarouge (143) est agencée à l'écart de la troisième région A ($123_1$) et de la quatrième région A ($124_1$) le long de la direction d'incidence d'infrarouge et est reliée thermiquement au troisième élément de détection de température (123),

la quatrième couche d'absorption d'infrarouge (144) est agencée à l'écart de la troisième région B ($123_2$) et de la quatrième région B ($124_2$) le long de la direction d'incidence d'infrarouge et est reliée thermiquement au quatrième élément de détection de température (124),

la cinquième couche d'absorption d'infrarouge (145) est agencée à l'écart de la cinquième région A ($125_1$) et de la sixième région A ($126_1$) le long de la direction d'incidence d'infrarouge et est reliée thermiquement au cinquième élément de détection de température (125),

la sixième couche d'absorption d'infrarouge (146) est agencée à l'écart de la cinquième région B ($125_2$) et de la sixième région B ($126_2$) le long de la direction d'incidence d'infrarouge et est reliée thermiquement au sixième élément de détection de température (126),

la septième couche d'absorption d'infrarouge (147) est agencée à l'écart de la septième région A ($127_1$) et de la huitième région A ($128_1$) le long de la direction d'incidence d'infrarouge et est reliée thermiquement au septième élément de détection de température (127), et

la huitième couche d'absorption d'infrarouge (148) est agencée à l'écart de la septième région B ($127_2$) et de la huitième région B ($128_2$) le long de la direction d'incidence d'infrarouge et est reliée thermiquement au huitième élément de détection de température (128).

# FIG. 1A

# FIG. 1B

# FIG. 2

# FIG. 3

# FIG. 4A

# FIG. 4B

# FIG. 5

# FIG. 6A

# FIG. 6B

# FIG. 7

# FIG. 8

# FIG. 9

# FIG. 10

# FIG. 11

# FIG. 12

# FIG. 13

FIG. 14

# FIG. 15

FIRST DIRECTION

SECOND DIRECTION

34a  24a

44a'

44a

# FIG. 16

# FIG. 17

FIG. 18

# FIG. 19

# FIG. 20

# FIG. 21

# FIG. 22

# FIG. 23

# FIG. 24

# FIG. 25

PERIPHERAL PORTION OF
TEMPERATURE DETECTION ELEMENT ARRAY

REGION BETWEEN CENTRAL PORTION AND PERIPHERAL PORTION
OF TEMPERATURE DETECTION ELEMENT ARRAY

CENTRAL PORTION OF TEMPERATURE DETECTION ELEMENT ARRAY

# FIG. 26

PERIPHERAL PORTION OF
TEMPERATURE DETECTION ELEMENT ARRAY

REGION BETWEEN CENTRAL PORTION AND PERIPHERAL PORTION
OF TEMPERATURE DETECTION ELEMENT ARRAY

CENTRAL PORTION OF TEMPERATURE DETECTION ELEMENT ARRAY

# FIG. 27

SECOND DIRECTION

# FIG. 28

FIRST DIRECTION       SECOND DIRECTION

# FIG. 29

# FIG. 30

SECOND DIRECTION

# FIG. 31

FIRST DIRECTION

SECOND DIRECTION

## FIG. 32

## FIG. 33A

## FIG. 33B

## FIG. 33C

## FIG. 33D

# FIG. 34A

# FIG. 34B

# FIG. 34C

## FIG. 35A

## FIG. 35B

## *FIG. 36A*

## *FIG. 36B*

**EP 3 805 718 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007171170 A
- JP 2018040791 A
- JP 2002296117 A
- US 2018143078 A1
- US 2009146059 A1
- US 2003057372 A1
- US 2015357361 A1